(19)

Europäisches
Patentamt
European
Patent Office
Office européen
des brevets

(11) **EP 3 557 506 A1**

(12) **EUROPEAN PATENT APPLICATION**

(43) Date of publication:
23.10.2019 Bulletin 2019/43

(51) Int Cl.:
*G06Q 10/04* (2012.01)          *G06Q 10/06* (2012.01)
*G06Q 50/30* (2012.01)

(21) Application number: 19161902.2

(22) Date of filing: 11.03.2019

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: 16.04.2018 JP 2018078764

(71) Applicant: **Hitachi, Ltd.**
**Tokyo 100-8280 (JP)**

(72) Inventors:
• **MAEKAWA, Yuki**
  **Tokyo 100-8280 (JP)**
• **TOMIYAMA, Tomoe**
  **Tokyo 100-8280 (JP)**
• **OKAHARA, Natsumi**
  **Tokyo 100-8280 (JP)**
• **TAKAI, Tomohito**
  **Tokyo 100-8280 (JP)**

(74) Representative: **MERH-IP Matias Erny Reichl
Hoffmann
Patentanwälte PartG mbB
Paul-Heyse-Strasse 29
80336 München (DE)**

(54) **SCHEDULE ANALYSIS SUPPORT DEVICE AND METHOD**

(57)    The present invention proposes a schedule analysis support device and method, which make it easier to reduce work time and facilitate work in the analysis of a schedule. A statistical model of a delay time of each mobile body to a plan schedule is generated in a predetermined section on the basis of the plan schedule, an actual schedule that is a daily travel result of the mobile body, and actual values of delay factors in the section in a chronological order, at least either of past result analysis processing of classifying a first delay time that is a delay time of the mobile body in the section into second delay times that are delay times of the delay factors in the section of the mobile body on the basis of the generated statistical model and the actual values of the delay factors and future prediction analysis processing of predicting a third delay time that is a delay time of a requested mobile body in the section on the basis of the statistical model and assumed values of the delay factors with respect of a new plan schedule is executed, and a processing result of the past result analysis processing or the future prediction analysis processing is displayed in a predetermined representation form.

FIG. 1

**EP 3 557 506 A1**

**Description**

BACKGROUND

The present invention: relates to a schedule analysis support device and method; and is preferably applicable to a schedule analysis support device to support analysis work of a train schedule, for example.

A schedule of a train has heretofore been produced manually in consideration of the convenience of a passenger and the profitability of a railway company while multifaceted decision factors such as urban development or decline, an economic situation, and the like are used as input sources. In a railway transport system for travelling urban suburbs in particular, a schedule is produced from the viewpoint of how to transport passengers without delay during rush hours. This is because, once a delay occurs, a delay generated secondarily (hereunder referred to as a secondary delay) by an original delay, including the increase of time required for getting on and off, the increase of an accident risk caused by congestion at a station platform, and the delay of a following train accompanying the delay of a preceding train, expands.

Further, a railway company: spends a long time to collect actual traveling schedules of trains (hereunder referred to as actual schedules), on-site voices, and opinions of passengers; and analyzes and specifies a place in a schedule where a delay of a train is likely to occur in order to improve the delay by the revision of a schedule or the change of operation. The "change of operation" here means special operation, such as the omission of transfer announcement, not shown in a schedule. There are some actual cases of being able to reduce the disturbance of a schedule by shortening and omitting announcement. Even now, an experienced person in charge addresses the analysis work of such a schedule while relying on a wide variety of data, lots of effort and time, and a sense.

As a technology related to such a schedule analysis, Japanese Patent Application No. 2008-114779 discloses an invention of being able to visually acquire the trends of departure and arrival delays by drawing delay times obtained from a reference schedule and a comparative schedule on a graph of frequency distribution/cumulative relative frequency distribution.

SUMMARY

The invention disclosed in Japanese Patent Application No. 2008-114779 however has the problem of not being able to analyze delays for each factor although it has means for analyzing delays for each type. Further, the invention disclosed in Japanese Patent Application No. 2008-114779 cannot eliminate the influence of a secondary delay and also has the problem of not being able to correctly analyze the delay of a train alone.

The present invention: has been established in consideration of the above situation; and proposes a schedule analysis support device and a method that can more reduce work time and facilitate work in the analysis of a schedule.

In the present invention, in order to solve the above problem, a schedule analysis support device to support analysis work of schedules of mobile bodies in a transport system is configured to include: a model generation unit to generate a statistical model of a delay time of each of the mobile bodies to a plan schedule that is a transport schedule preplanned for the mobile body in each predetermined section on the basis of the plan schedule, an actual schedule that is a daily travel result of the mobile body, and actual values of respective delay factors in the section in chronological order; an analysis unit to execute at least either of past result analysis processing of classifying a first delay time that is a delay time of the mobile body in the section into second delay times that are delay times of the delay factors in the section of the mobile body on the basis of the generated statistical model and the actual values of the delay factors and future prediction analysis processing of predicting a third delay time that is a delay time of a requested mobile body in the section on the basis of the statistical model and assumed values of the delay factors with respect to a new plan schedule; and/or an output unit to display a processing result of the past result analysis processing or the future prediction analysis processing in a predetermined representation form.

Further, in the present invention, a schedule analysis support method executed by a schedule analysis support device to support analysis work of schedules of mobile bodies in a transport system is configured to include: a first step of generating a statistical model of a delay time of each of the mobile bodies to a plan schedule that is a transport schedule preplanned for the mobile body in each predetermined section on the basis of the plan schedule, an actual schedule that is a daily travel result of the mobile body, and actual values of respective delay factors in the section in chronological order; a second step of executing at least either of past result analysis processing of classifying a first delay time that is a delay time of the mobile body in the section into second delay times that are delay times of the delay factors in the section of the mobile body on the basis of the generated statistical model and the actual values of the delay factors and future prediction analysis processing of predicting a third delay time that is a delay time of a requested mobile body in the section on the basis of the statistical model and assumed values of the delay factors with respect to a new plan schedule; and/or a third step of displaying a processing result of the past result analysis processing or the future prediction analysis processing in a predetermined representation form.

By a schedule analysis support device and a method according to the present invention, a user can easily know the influence of each delay factor on a delay time of each train in each section between stations.

The present invention makes it easier to reduce work time and facilitate work in the analysis of a schedule.

BRIEF DESCRIPTION OF THE DRAWINGS

FIG. 1 is a block diagram showing an overall configuration of a schedule analysis support device according to the present embodiment;
FIG. 2 is a table showing a configuration example of a plan schedule management table;
FIG. 3 is a table showing a configuration example of an actual schedule management table;
FIG. 4 is a table showing a configuration example of a train delay time management table;
FIG. 5 is a table showing a configuration example of a schedule restriction management table;
FIG. 6 is a table showing a configuration example of a delay factor management table;
FIG. 7 is a table showing a configuration example of a post-refinement train delay time management table;
FIG. 8 is a table showing a configuration example of a delay-factor-specific result management table;
FIG. 9 is a table showing a configuration example of an analysis method management table;
FIG. 10 is a table showing a configuration example of a delay model management table;
FIG. 11 is a view showing a configuration example of an analysis mode designation screen;
FIG. 12 is a view showing a configuration example of a visualization parameter designation screen;
FIG. 13 is a view showing a configuration example of a schedule analysis result display screen;
FIGS. 14A and 14B are views used for explaining a relationship between visualization parameters and a display state on a schedule analysis result display screen;
FIGS. 15A and 15B are views used for explaining a relationship between visualization parameters and a display state on a schedule analysis result display screen;
FIGS. 16A and 16B are views used for explaining a relationship between visualization parameters and a display state on a schedule analysis result display screen;
FIGS. 17A and 17B are views used for explaining a relationship between visualization parameters and a display state on a schedule analysis result display screen;
FIG. 18 is a view showing a configuration example of a simulation setting screen;
FIG. 19 is a flowchart showing a processing procedure of schedule analysis processing;
FIG. 20 is a flowchart showing a processing procedure of mode setting processing;
FIG. 21 is a flowchart showing a processing procedure of plan schedule read processing;
FIG. 22 is a flowchart showing a processing procedure of actual data read processing;
FIG. 23 is a flowchart showing a processing procedure of delay time calculation processing;
FIG. 24 is a flowchart showing a processing procedure of delay time refinement processing;
FIGS. 25A to 25D represent tables and a graph used for explaining delay time refinement processing;
FIGS. 26A to 26D represent tables and a graph used for explaining delay time refinement processing;
FIG. 27 is a flowchart showing a processing procedure of delay model generation processing;
FIG. 28 is a flowchart showing a processing procedure of past result analysis processing;
FIG. 29 is a flowchart showing a processing procedure of future prediction analysis processing; and
FIG. 30 is a flowchart showing a processing procedure of analysis result output processing.

DETAILED DESCRIPTION

An embodiment according to the present invention is explained hereunder in detail in reference to the drawings.

(1) Configuration of schedule analysis support device according to present embodiment

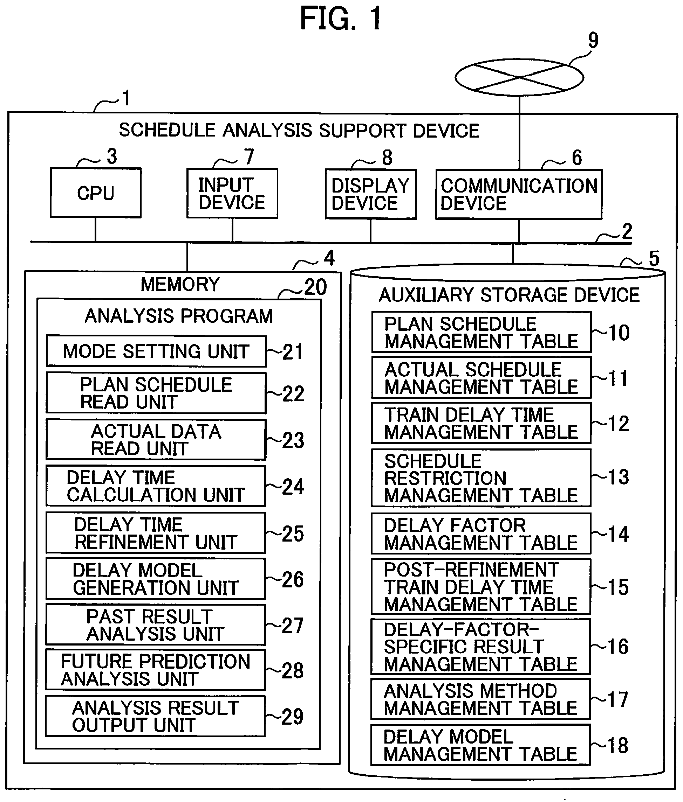

In FIG. 1, the numerical sign 1 shows a schedule analysis support device according to the present embodiment as a whole. The schedule analysis support device 1 includes a general-purpose computer device having a CPU (Central Processing Unit) 3, a memory 4, an auxiliary storage device 5, a communication device 6, an input device 7, and a display device 8, which are connected to each other with an internal bus 2 interposed.

The CPU 3 is a processor to control the operations of the entire schedule analysis support device 1. Further, the memory 4: includes a volatile semiconductor memory such as a DRAM (Dynamic RAM (Random Access Memory)) or an SRAM (Static RAM) for example; and is used as a work memory of the CPU 3.

The auxiliary storage device 5: includes a nonvolatile large-capacity storage device such as a hard disk device or an SSD (Solid-State Drive) for example; and is used for retaining a program and necessary data for a long period of time. A program stored in the auxiliary storage device 5 is read out to the memory 4 at the start of the schedule analysis support device 1 or when necessary, the CPU 3 executes the program, and thus various kinds of processing that will be described later is executed.

The communication device 6: includes an NIC (Network Interface Card) for example; and executes protocol control during communication with an external device through a communication network 9 such as the Internet. Further, the input device 7: includes a keyboard or a mouse for example; and is used when a user applies various operations to the schedule analysis support device 1. Furthermore, the display device 8: includes a liquid crystal display or an organic EL (Electro Luminescence) display for example; and is used for displaying a necessary screen or information.

(2) Schedule analysis support function according to present embodiment

Successively, a schedule analysis support function installed in the schedule analysis support device 1 is explained hereunder. A schedule analysis support function to support the analysis work of an operation schedule of a train is installed in the schedule analysis support device 1.

Actually, the schedule analysis support device 1, as schedule analysis processing based on such a schedule analysis support function, generates a delay model of a delay time of each train to a transport schedule preplanned for the train (hereunder referred to as a plan schedule) in each section between stations (the section is hereunder referred to as a station section) on the basis of the plan schedule, an actual schedule that is a daily travel result of the train, and actual values of factors that can cause a train to be delayed (hereunder referred to as delay factors) in the station section in a chronological order.

As "delay factors" here, precipitation (rain), wind, snowfall, a train occupancy by passengers, the number of passengers on platforms (the number of passengers staying on platforms) at stations on the departure side and the arrival side of a corresponding station section, presence or absence of a large-scale event around a station, and the like are named. Further, a "delay model" means a statistical model of a delay time of a train in a station section produced on the basis of past actual values of delay factors in the station section of the train and an actual delay time in the station section. The delay model is defined as a function that has: delay factors as variables; and the degree (weight) of influence of each delay factor on the delay of a train as a coefficient of the corresponding variable.

Then the schedule analysis support device 1, when a designated analysis mode is a past analysis mode of analyzing past results of train delay, executes past result analysis processing of classifying a delay time of each train in each station section into delay times of respective delay factors on the basis of a generated delay model in the station section of the train and actual values of the delay factors in the station section during the travel of the train. Further, the schedule analysis support device 1, when a designated analysis mode is a future prediction mode of predicting a delay time of each train in each station section in a new plan schedule, executes future prediction analysis processing of predicting the delay times of respective delay factors in each station section of each train on the basis of a delay model and assumed values of the delay factors with regard to the new plan schedule.

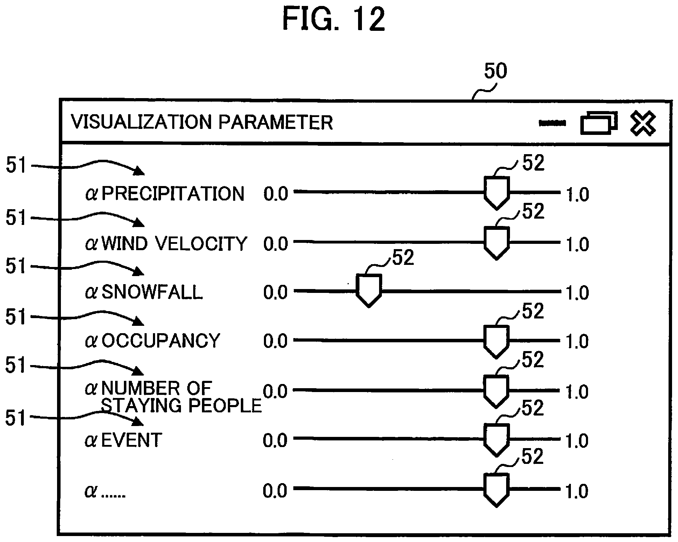

Then the schedule analysis support device 1, during a past analysis mode, calculates a delay time of each train in each station section by: multiplying delay times of respective delay factors in the station section of the train by magnifications (0 to 1 in the present embodiment) of the delay factors designated by a user in a visualization parameter designation screen 50 that will be described later in reference to FIG. 12; and further adding up the multiplication results of the delay factors. A delay time calculated in this way is an estimated value of a delay time of a train in a station section that is anticipated when a user lowers the influence of the delay factors to designated magnifications in the visualization parameter designation screen 50 in the station section of the train.

By setting the magnification of a desired delay factor at "1" and setting the magnifications of all the other delay factors at "0" therefore, an estimated value of a delay time caused only by the delay factor the magnification of which is set at "1" included in a delay time of each train in each station section can be obtained in the station section of the train and, in the same way as this, for each of the delay factors, an estimated value of a delay time caused only by a designated delay factor can be obtained in each station section of each train. Further, by adjusting the values of the magnifications of delay factors, an estimated value of a delay time caused by the combination of arbitrary two or more delay factors can also be obtained.

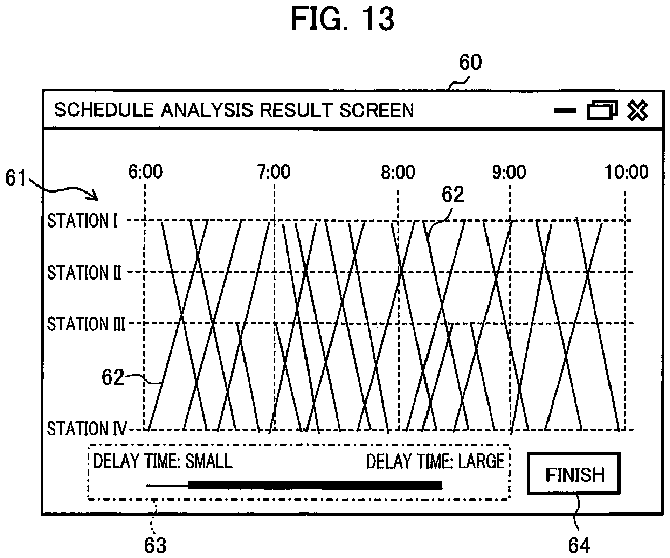

Further, the schedule analysis support device 1 displays a schedule analysis result display screen 60 that will be described later in reference to FIG. 13 in which estimated values of delay times in respective station sections of respective trains caused by one or more delay factors calculated in this way are represented in a predetermined representation form on the display device 8.

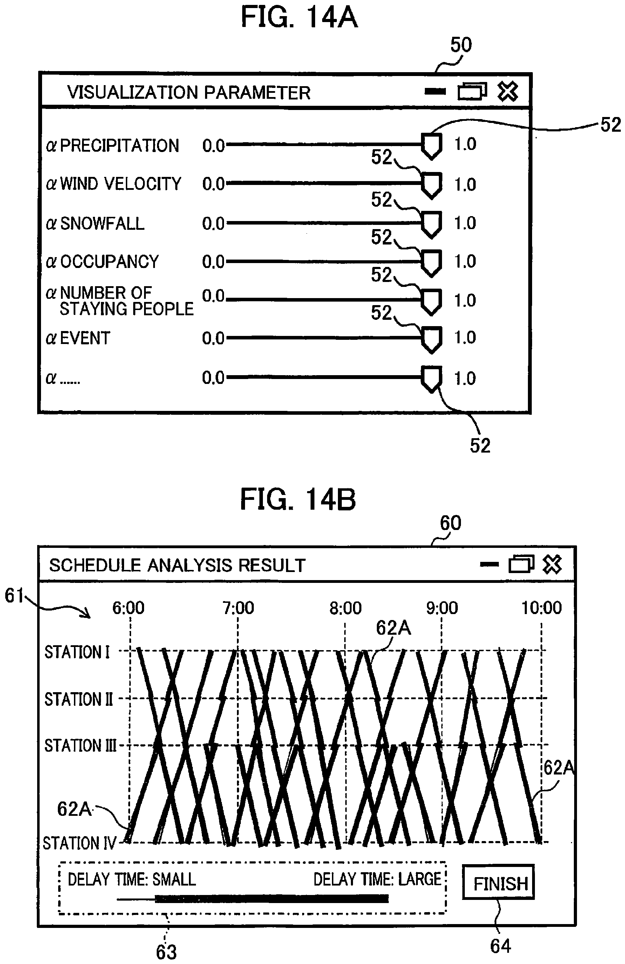

Actually, in the schedule analysis result display screen 60, in each station section of each train, an estimated value of a delay time caused by one or more delay factors calculated as stated above: is represented as a line segment 62A having a color tone corresponding to the magnitude of the estimated value as it will be described later in reference to FIGS. 14B, 15B, 16B, and 17B; and is displayed in the manner of overlapping with the part of a corresponding station section in a line segment 62 representing a schedule of a corresponding train in a diagram 61 of a plan schedule targeted at that time.

A user therefore can visually more intuitively acquire the magnitude of a delay time caused only by one delay factor or the magnitude of a delay time caused by multiple delay factors in each station section of each train on the basis of a color tone of a line segment 62A displayed in the schedule analysis result display screen 60 by setting the magnifications of delay factors designated in the visualization parameter designation screen 50 at desired values respectively.

Further, the schedule analysis support device 1, during the future prediction mode, in each station section of each train in a new plan schedule: calculates delay times of respective delay factors in the station section of the train; multiplies the delay times by magnifications of the delay factors designated by a user in the visualization parameter designation screen 50 (FIG. 12); further adds up the multiplication results of the delay factors; and thus calculates a predicted value of a delay time. A delay time calculated in this way is a predicted value of a delay time of the train in the station section that is anticipated when a user lowers the influence of the delay factors to respective designated magnifications in the visualization parameter designation screen 50 in the station section of the train with respect to the new plan schedule.

By setting the magnification of a desired delay factor at "1" and setting the magnifications of all the other delay factors at "0" therefore, a predicted value of a delay time caused only by the delay factor the magnification of which is set at "1" included in a delay time of each train in each station section can be obtained in the station section of the train and, in the same way as this, a predicted value of a delay time caused only by a designated delay factor can be obtained in each station section of each train. Further, by adjusting the values of the magnifications of delay factors, a predicted value of a delay time caused by the combination of arbitrary two or more delay factors can also be obtained.

Then the schedule analysis support device 1 displays a predicted value of a delay time of each train in each station section caused by one or more delay factors calculated in this way in the schedule analysis result display screen 60 similarly to the past result analysis processing.

A user therefore can visually more intuitively acquire the magnitude of a delay time caused only by one delay factor or the magnitude of a delay time caused by multiple delay factors in each station section of each station on the basis of a color tone of a line segment 62A displayed in the schedule analysis result display screen 60 with regard to a new plan schedule by setting the magnifications of delay factors designated in the visualization parameter designation screen 50 at desired values respectively.

As means for materializing such a schedule analysis support function according to the present embodiment, a plan schedule management table 10, an actual schedule management table 11, a train delay time management table 12, a schedule restriction management table 13, a delay factor management table 14, a post-refinement train delay time management table 15, a delay-factor-specific result management table 16, an analysis method management table 17, and a delay model management table 18 are stored in an auxiliary storage device 5 of the schedule analysis support device 1.

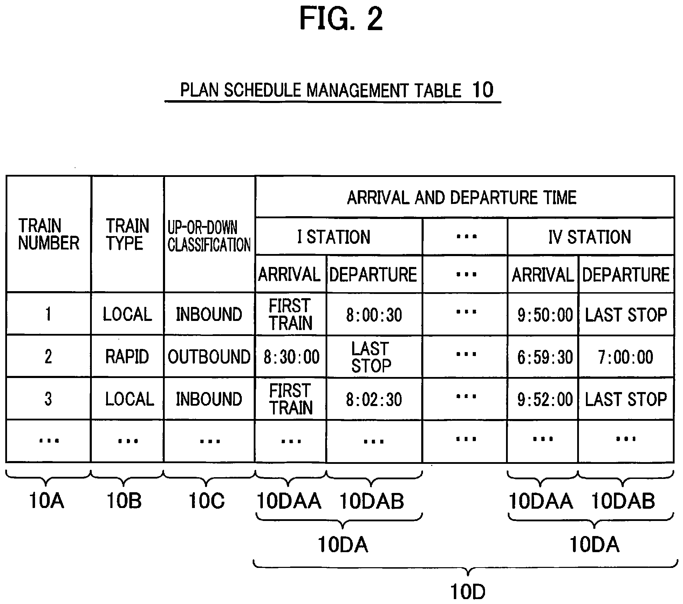

The plan schedule management table 10 is a table used for managing an existing plan schedule of a railway to be an analysis target (the railway is hereunder referred to as a target railway) and a new plan schedule made for a new railway. The plan schedule management table 10 includes a train number column 10A, a train type column 10B, an up-or-down classification column 10C, and an arrival and departure time column 10D as shown in FIG. 2.

Then in the train number column 10A, an identification number (train number) intrinsic to a train given to each train traveling along a target railway is stored. In the case of the present embodiment here, when an identical train shuttles once or more than once a day, the train is managed as different trains for each one-way and different numbers are given to the different trains.

Further, a train type, such as "local", "rapid", or "express", of the train of a train number is stored in the train type column 10B and the up or down, such as "inbound" or "outbound", of a train is stored in the up-or-down classification column 10C.

The arrival and departure time column 10D is classified into a plurality of station arrival and departure time columns 10DA so as to correspond to respective stations on a target railway. Further, each of the station arrival PREDICTION and departure time columns 10DA is classified into an arrival column 10DAA and a departure column 10DAB, and an estimated time when a train arrives at a station is stored in an arrival column 10DAA and an estimated time when a train departs from a station is stored in a departure column 10DAB.

The case of the example in FIG. 2 therefore shows for example that a schedule is made up so that the train to which the train number "1" is given: may be a "local" train of "inbound" which departs from "I Station" and arrives finally at "IV Station"; and may depart from "I Station" at "8:00:30" and may arrive at "IV Station" at "9:50:00".

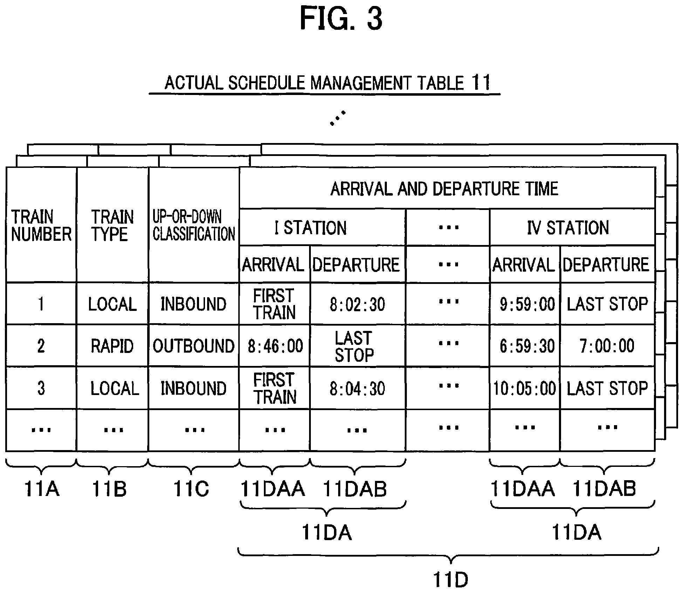

Further, the actual schedule management table 11: is a table used for managing an actual schedule of each train that has travelled along a target railway; and is made every day. The actual schedule management table 11 includes a train number column 11A, a train type column 11B, an up-or-down classification column 11C, and an arrival and departure time column 11D as shown in FIG. 3.

Then in the train number column 11A, the train type column 11B, and the up-or-down classification column 11C, information similar to the corresponding columns (the train number column 10A, the train type column 10B, and the up-or-down classification column 10C) in the plan schedule management table 10 is stored, respectively.

Further, the arrival and departure time column 11D is, similarly to the arrival and departure time column 10D in the plan schedule management table 10, classified into a plurality of station arrival and departure time columns 11DA so as to correspond to respective stations on a target railway. Then, each of the station arrival and departure time columns 11DA is classified into an arrival column 11DAA and a departure column 11DAB, and an actual time when a train arrives at a station is stored in an arrival column 11DAA and an actual time when a train departs from a station is stored in a departure column 11DAB.

The case of the example in FIG. 3 therefore shows for example that, with regard to the train to which the train number of "1" is given, the actual time when the train departs from "I Station" is "8:02:30" and the actual time when the train arrives at "IV Station" is "9:59:00" on a corresponding date in comparison with the plan schedule stated above in reference to FIG. 2.

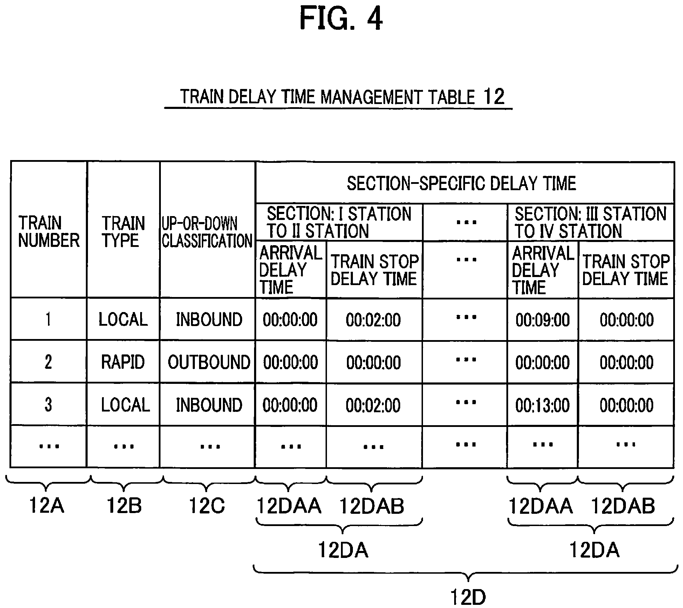

The train delay time management table 12: is a table used for managing a delay time of each train in each station section; and is made every day. The train delay time management table 12 includes a train number column 12A, a train type column 12B, an up-or-down classification column 12C, and a section-specific delay time column 12D as shown in FIG. 4.

Then in the train number column 12A, the train type column 12B, and the up-or-down classification column 12C, information similar to the corresponding columns (the train number column 10A, the train type column 10B, and the up-or-down classification column 10C) in the plan schedule management table 10 is stored, respectively.

Further, the section-specific delay time column 12D is classified into a plurality of station section columns 12DA so as to correspond to respective stations on a target railway and each of the station section columns 12DA is classified into an arrival delay time column 12DAA and a train stop delay time column 12DAB. Then, a delay time from a plan schedule of a time when a train arrives at a station on the arrival side of a station section is stored in the arrival delay time column 12DAA and a difference between a stop time of a train at a station on the arrival side of a station section and a stop time of the train at the station in the plan schedule is stored as a train stop delay time in the train stop delay time column 12DAB.

The case of the example in FIG. 4 therefore shows for example that, with regard to the train to which the train number of "1" is given, although the time when the train arrives at "II Station" does not delay ("00:00:00") in the station section between "I Station" and the next "II Station", the time when the train departs from "II Station" delays by 2 minutes ("00:02:00") on a corresponding date in comparison with the plan schedule stated above in reference to FIG. 2.

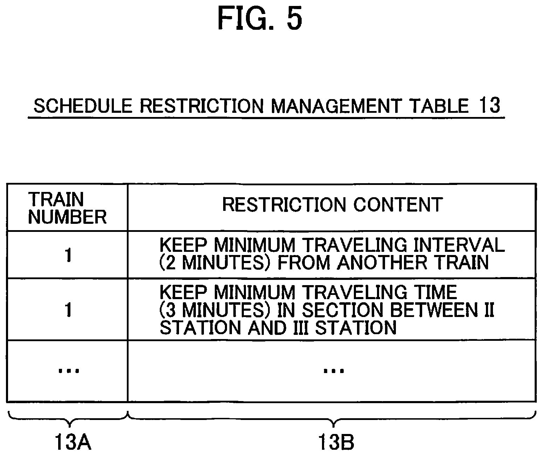

The schedule restriction management table 13: is a table used for managing the restriction of a train during travelling specified for each train (the restriction is hereunder referred to as schedule restriction) ; and includes a train number column 13A and a restriction content column 13B as shown in FIG. 5. In the schedule restriction management table 13, one row corresponds to one schedule restriction.

Then the train number of a train to which a schedule restriction is applied is stored in the train number column 13A and a specific content of the schedule restriction is stored in the restriction content column 13B. The case of the example in FIG. 5 therefore shows that, with respect to the train having the train number of "1", to travel by keeping an operation interval of 2 minutes or more apart from a preceding train ("a minimum traveling interval from another train is "2 minutes"") and to travel between II Station and III Station over a period of 3 minutes or more ("to keep a minimum traveling time (3 minutes) in the section between II Station and III Station") are specified as the schedule restrictions.

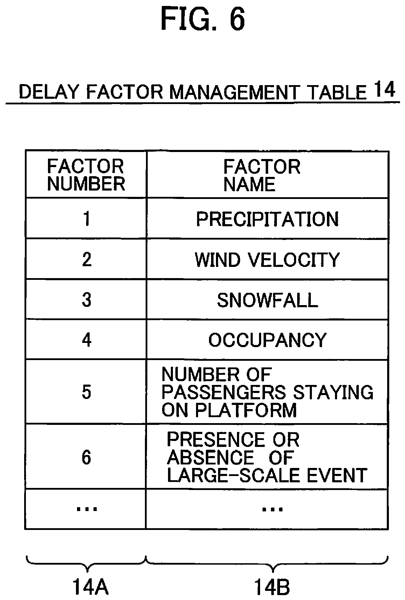

The delay factor management table 14: is a table used for managing a delay factor of preselected train delay; and includes a factor number column 14A and a factor name column 14B as shown in FIG. 6. Then an identification number intrinsic to a delay factor given to the corresponding delay factor is stored in the factor number column 14A and a name (content) of the corresponding delay factor is stored in the factor name column 14B.

The case of the example in FIG. 6 therefore shows that, as the factors of train delay, rain ("precipitation"), wind ("wind velocity"), snow ("snowfall"), congestion in a coach ("occupancy"), a number of passengers on a platform ("a number of passengers staying on a platform"), the presence or absence of a large-scale event around a station ("the presence or absence of a large-scale event"), and the like are named.

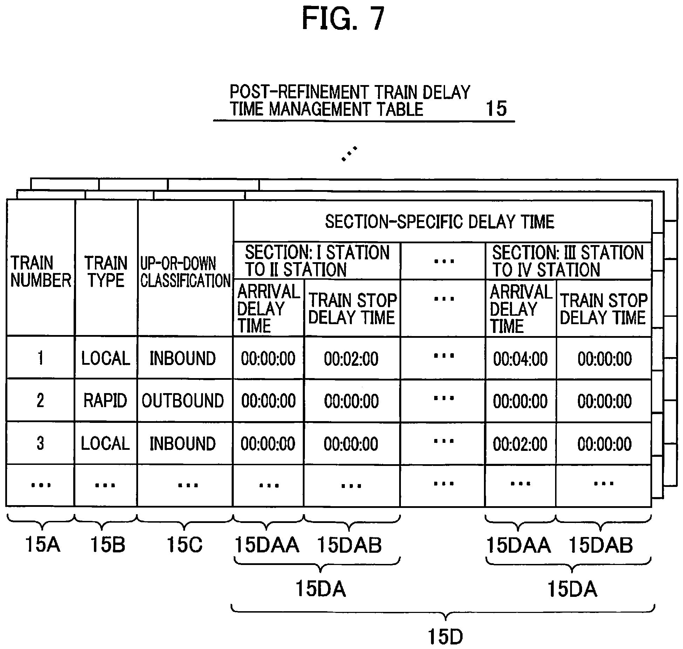

The post-refinement train delay time management table 15: is a table used for managing a delay time of each train in each station section after the influence of secondary delay (the influence of delay of a preceding train, the influence of delay of the relevant train in a previous station section, and the like) is excluded while schedule restrictions are taken into consideration and; is made every day. The post-refinement train delay time management table 15 includes a train number column 15A, a train type column 15B, an up-or-down classification column 15C, and a section-specific delay time column 15D as shown in FIG. 7.

Then in the train number column 15A, the train type column 15B, and the up-or-down classification column 15C, information similar to the corresponding columns (the train number column 12A, the train type column 12B, and the up-or-down classification column 12C) in the train delay time management table 12 (FIG. 4) is stored, respectively.

The section-specific delay time column 15D is classified into a plurality of station section columns 15DA so as to correspond to respective station sections on a target railway. Further, each of the station section columns 15DA is classified into an arrival delay time column 15DAA and a train stop delay time column 15DAB.

Then in the arrival delay time column 15DAA, a delay time from a plan schedule of a predicted arrival time when a train arrives at a station on the arrival side of a station section when the influence of secondary delay is excluded while schedule restrictions are taken into consideration is stored. Further, in the train stop delay time column 15DAB, a difference (train stop delay time) between a stop time of a train at a station on the arrival side of a station section and a stop time of the train at the station in the plan schedule when the influence of secondary delay is excluded while schedule restrictions are taken into consideration is stored.

In the case of the example in FIG. 7 therefore, with regard to the train having a train number of "1" for example, it is obvious that, in the station section of "III Station to IV Station", the delay time of the arrival time at III Station estimated when the influence of secondary delay is excluded while the schedule restrictions are taken into consideration is "00:04:00" and hence the delay time is shortened by 5 minutes in comparison with the case of not excluding the influence of secondary delay as stated above in reference to FIG. 4. The 5 minutes therefore can be thought to be the secondary delay.

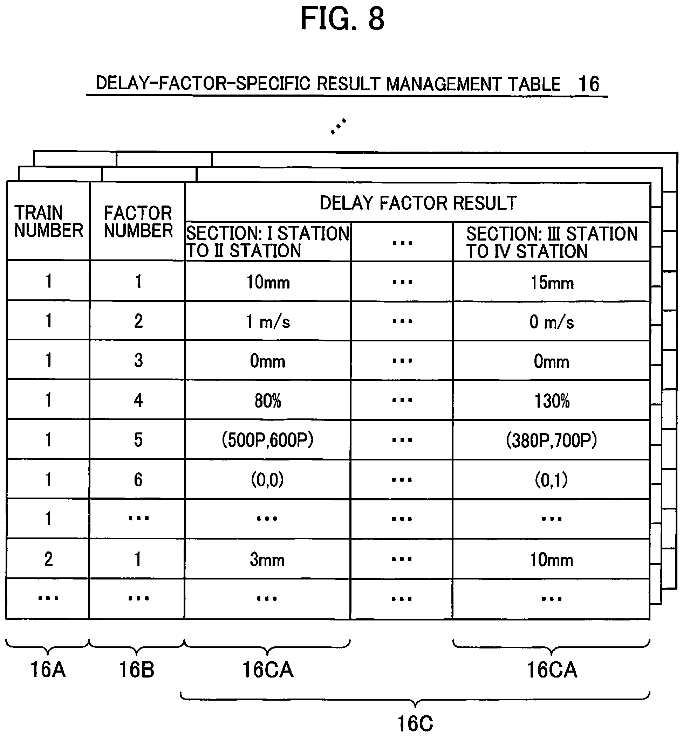

The delay-factor-specific result management table 16: is a table used for managing an actual value of each of delay factors in each station section during the operation of each train; and is made every day. The delay-factor-specific result management table 16 includes a train number column 16A, a factor number column 16B, and a delay factor result column 16C as shown in FIG. 8.

Then a train number of a train is stored in the train number column 16A and a factor number of a delay factor is stored in the factor number column 16B. Further, the delay factor result column 16C is classified into a plurality of station section columns 16CA so as to correspond to respective station sections on a target railway and, in each of the station section columns 16CA, an actual value of a delay factor when a train travels in a station section is stored.

In the case of the example in FIG. 8 therefore, on a corresponding date, it is shown that the value of the delay factor ("precipitation") having the factor number of "1" when the train having the train number of "1" travels from the "A" station toward the B station is "10 mm", the value of the delay factor ("wind velocity") having the factor number of "2" is "1 m/s", the value of the delay factor ("snowfall") having the factor number of "3" is "0 mm", the value of the delay factor ("occupancy") having the factor number of "4" is "80%", the value of the delay factor ("number of passengers staying on a platform") having the factor number of "5" is "500 people" at the departure station and "600 people" at the arrival station ("(500 people, 600 people)"), the delay factor ("presence or absence of a large-scale event") having the factor number of "6" is absent ("0,0") at both the station on the departure side and the station on the arrival side, and so on.

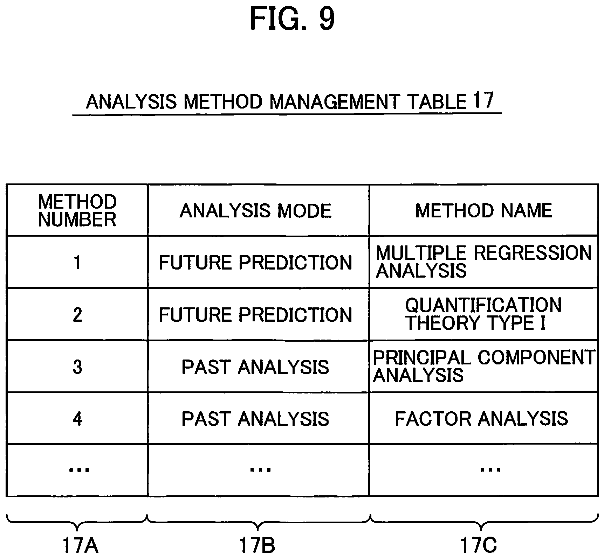

The analysis method management table 17: is a table used for managing an analysis method in each of predetermined analysis modes; and includes a method number column 17A, an analysis mode column 17B, and a method name column 17C as shown in FIG. 9.

Meanwhile, in the case of the present embodiment, as analysis modes, there are two analysis modes of a past analysis mode of analyzing a past result of train delay and a future prediction mode of predicting a delay time of each train in each station section in a new plan schedule, as stated above.

Then an identification number (method number) given to each combination of an analysis mode and an analysis method is stored in the method number column 17A and information representing whether the analysis mode in a combination is a past analysis mode or a future prediction mode ("past analysis" in the case of a past analysis mode and "future prediction" in the case of a future prediction mode) is stored in the analysis mode column 17B.

Further, the name of an analysis method used in a combination is stored in the method name column 17C. In the present embodiment, as such an analysis method, a multiple regression analysis method, a quantification I class method, a principal component analysis method, a factor analysis method, or the like is used and hence a name ("multiple regression analysis", "quantification I class", "principal component analysis", "factor analysis", or the like) of such an analysis method is stored in the method name column 17C.

Meanwhile, in the case of the present embodiment, the "factor analysis" method is set as the default of an analysis method used in the past analysis mode and the "multiple regression analysis" method is set as the default of an analysis method used in the future prediction mode.

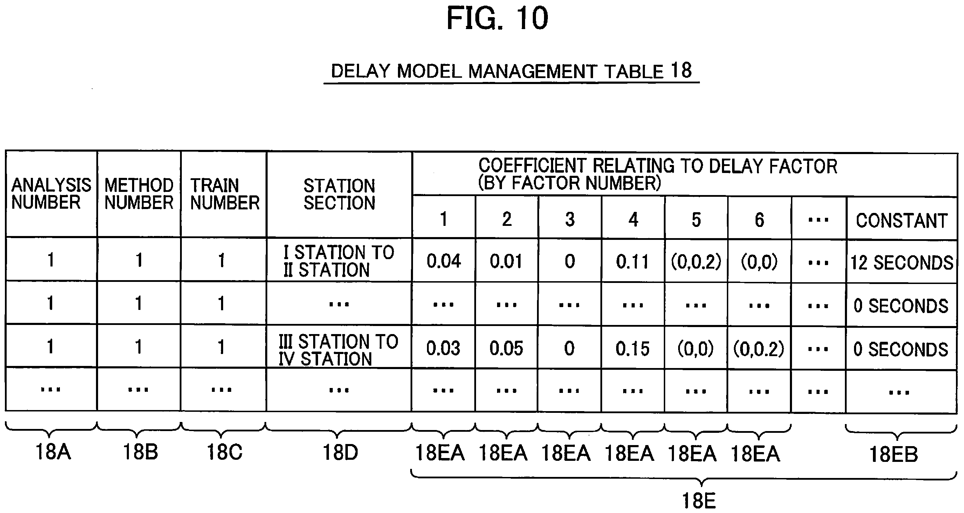

The delay model management table 18 is a table used for managing a delay model generated in each station section of each train. The delay model management table 18 includes an analysis number column 18A, a method number column 18B, a train number column 18C, a station section column 18D, and a delay factor coefficient column 18E as shown in FIG. 10. In the delay model management table 18, one delay model corresponds to one station section of one train.

Then an identification number (analysis number) intrinsic to a delay model given to the delay model is stored in the analysis number column 18A and a method number of an analysis method used for generating the delay model is stored in the method number column 18B. Further, a train number of a train with which the delay model is associated is stored in the train number column 18C and identification information of a station section with which the delay model is associated is stored in the station section column 18D.

Furthermore, the delay factor coefficient column 18E is classified into a plurality of coefficient columns 18EA, which are associated with respective delay factors registered in the delay factor management table 14, and a constant column 18EB. Then a value of a coefficient of a delay factor corresponding to a factor number in a delay model (function) calculated by using a corresponding analysis method is stored in each of the coefficient columns 18EA and a value of a constant in the delay model (function) is stored in the constant column 18EB.

In the case of the example in FIG. 10 therefore, it is shown that, in the delay model generated in the station section of "I Station to II Station" of the train of "1" by using the analysis method having the analysis number of "1" (the multiple regression analysis method according to FIG. 9), the values of the coefficients of respective delay factors having the factor numbers of "1" to "6" ("precipitation", "wind velocity", "snowfall", "occupancy", "number of passengers staying on a platform", and "presence or absence of a large-scale event" respectively according to FIG. 6) are "0.04", "0.01", "0", "0.11", "(0, 0.2)", and "(0, 0)" respectively and the constant in the delay model is "12 seconds".

Meanwhile, as means for materializing such schedule analysis support function as stated above according to the present embodiment, in the memory 4 of the schedule analysis support device 1, an analysis program 20 including a mode setting unit 21, a plan schedule read unit 22, an actual data read unit 23, a delay time calculation unit 24, a delay time refinement unit 25, a delay model generation unit 26, a past result analysis unit 27, a future prediction analysis unit 28, and an analysis result output unit 29 is stored as shown in FIG. 1.

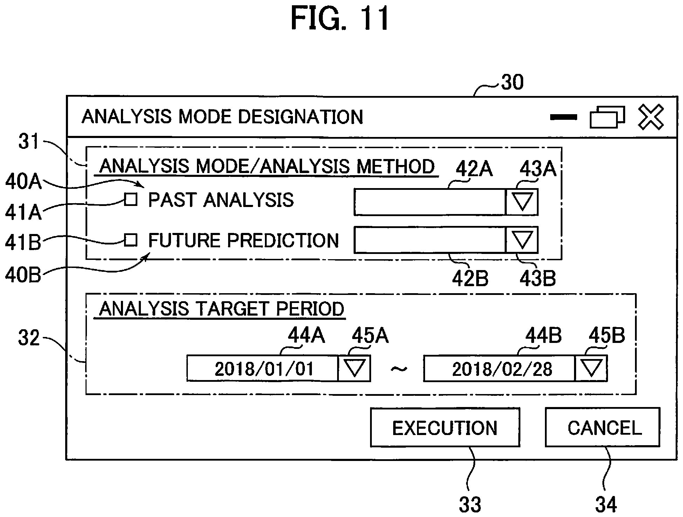

The mode setting unit 21 is a module having the function of: displaying an analysis mode designation screen 30 that will be described later in reference to FIG. 11 on the display device 8 (FIG. 1); and setting an operation mode of the schedule analysis support device 1 at an analysis mode designated by a user by using the analysis mode designation screen 30.

Further, the plan schedule read unit 22 is a module having the function of acquiring a plan schedule of an analysis target from the plan schedule management table 10 (FIG. 2). Furthermore, the actual data read unit 23 is a module having the function of: reading an actual schedule in each station section of each train during a target period of schedule analysis (the period is hereunder referred to as an analysis target period) designated by a user by using the analysis mode designation screen 30 (FIG. 11) from a corresponding actual schedule management table 11 (FIG. 3); and reading actual values of respective delay factors in the station section of the train during the analysis target period from a corresponding delay-factor-specific result management table 16 (FIG. 8).

The delay time calculation unit 24 is a module having the function of generating the train delay time management table 12 stated above in reference to FIG. 4. Actually, the delay time calculation unit 24: calculates a real delay time to a plan schedule in each station section of each train on the basis of the plan schedule in the station section of the train read from the plan schedule management table 10 by the plan schedule read unit 22, an actual schedule in the station section of the train during an analysis target period read from a necessary actual schedule management table 11 by the actual data read unit 23, and actual values of respective delay factors in the station section of the train during the analysis target period read from the delay-factor-specific result management table 16 by the actual data read unit 23; registers the calculation result in the train delay time management table 12; and manages the calculation result.

The delay time refinement unit 25 is a module having the function of calculating a delay time of each train in each station section during an analysis target period excluding the influence of secondary delay while the schedule restrictions of the train are taken into consideration. Actually, the delay time refinement unit 25 calculates a delay time of each train in each station section during an analysis target period excluding the influence of secondary delay while the schedule restrictions of the train registered in the schedule restriction management table 13 (FIG. 5) are taken into consideration. Then the delay time refinement unit 25 registers the calculation result in the post-refinement train delay time management table 15 and manages the calculation result.

The delay model generation unit 26 is a module having the function of generating a delay model on a delay time of each train in each station section in a target plan schedule by using an analysis method designated by a user.

For example, the delay model generation unit 26, when a multiple regression analysis method is designated by a user as an analysis method, by defining the values of delay factors as $x_1$, $x_2$, $x_3$, ······, the coefficients of those delay factors as $a_1$, $a_2$, $a_3$, ······, and the constant as b, a delay model on a delay time f of each train in each station section is generated as a function shown by the expression (1) .
[Num. 1]

$$f = a_1x_1 + a_2x_2 + a_3x_3 + \cdots + b \qquad (1)$$

Here, in the expression (1), the terms "$a_1x_1$", "$a_2x_2$", "$a_3x_3$", ···· represent delay times included in the delay time f of a certain train in a certain station section and caused only by corresponding delay factors respectively. Further, the "b" represents a delay time in the case of being influenced by none of the delay factors, namely a delay time generated regularly by being caused by a problem of a plan schedule itself or a facility itself. It can therefore be said that, in the delay model, a past delay time f is calculated by being classified into the delay times of respective delay factors (in the case of a past analysis mode) or a delay time f is calculated by adding up predicted values of the delay times of respective delay factors (in the case of a future prediction mode). Then the delay model generation unit 26 registers coefficients of respective delay factors in a generated delay model to the delay model management table 18 (FIG. 10) and manages the coefficients.

The past result analysis unit 27 is a module, during a past analysis mode, having the function of executing processing (past result analysis processing) of, in each station section of each train, calculating an estimated value of a delay time of the train in the station section by classifying a delay time of the train in the station section into delay times of respective delay factors and multiplying the classified delay times of the delay factors by magnifications given to the corresponding delay factors in the station section of the train on the basis of a delay model, an actual schedule of the train, and actual values of the delay factors of the train on a target railway.

Further, the future prediction analysis unit 28 is a module, during a future prediction mode, having the function of executing processing (future prediction analysis processing) of, in each station section of each train in a new plan schedule, calculating a predicted value of a delay time of the train in the station section by calculating delay times of respective delay factors in the station section of the train and multiplying the calculated delay times of the delay factors by magnifications given to the corresponding delay factors.

Furthermore, the analysis result output unit 29 is a module having the function of: generating a schedule analysis result display screen 60 representing the processing result of past result analysis processing executed by the past result analysis unit 27 and the processing result of future prediction analysis processing executed by the future prediction analysis unit 28 in a representation form that will be described later in reference to FIGS. 14B, 15B, 16B, and 17B; and displaying the screen on the display device 8.

The specific processing contents of the mode setting unit 21, the plan schedule read unit 22, the actual data read unit 23, the delay time calculation unit 24, the delay time refinement unit 25, the delay model generation unit 26, the past result analysis unit 27, the future prediction analysis unit 28, and the analysis result output unit 29 will be described later.

(3) Screen configurations of various screens

(3-1) Analysis mode designation screen

FIG. 11 shows an analysis mode designation screen 30 capable of being displayed on the display device 8 by operating a schedule analysis support device 1 according to the present embodiment. The analysis mode designation screen 30 is a screen for a user to designate an analysis mode, an analysis method, and an analysis target period in schedule analysis processing executed by the schedule analysis support device 1 in relation to a schedule analysis support function according to the aforementioned present embodiment. The analysis mode designation screen 30 includes an analysis mode/analysis method designation region 31, an analysis target period designation region 32, an execution button 33, and a cancel button 34.

In the analysis mode/analysis method designation region 31, character strings 40A and 40B of "past analysis" and "future prediction" and check boxes 41A and 41B formed so as to correspond to the character strings 40A and 40B respectively are displayed. Then in the analysis mode designation screen 30, a past analysis mode can be designated as the analysis mode of schedule analysis processing executed by clicking the check box 41A corresponding to the character string 40A of "past analysis" and displaying a check mark (not shown in the figure) in the check box 41A. Further, in the analysis mode designation screen 30, a future prediction mode can be designated as the analysis mode of schedule analysis executed by clicking the check box 41B corresponding to the character string 40B of "future prediction" and displaying a check mark (not shown in the figure) in the check box 41B.

Further, text boxes 42A and 42B and pull-down buttons 43A and 43B are displayed respectively on the right sides of the character strings 40A and 40B of "past analysis" and "future prediction" in the analysis mode/analysis method designation region 31. Then by clicking the pull-down button 43A or 43B, a pull-down menu (not shown in the figure) in which the method names of all the analysis methods usable in a corresponding analysis mode are described can be displayed. In this way, a user selects the name of a desired analysis method from the pull-down menu and hence can select the analysis method as an analysis method used during the analysis mode. The name of an analysis method selected at that time is displayed in a text box 42A or 42B displayed on the left side of the pull-down button 43A or 43B.

In the analysis target period designation region 32, text boxes 44A and 44B and pull-down buttons 45A and 45B are displayed so as to correspond to a start date and an end date in an analysis target period, respectively. Then by clicking the pull-down button 45A or 45B, a pull-down menu (not shown in the figure) in which a calendar is described can be displayed. In this way, a user selects a desired date in the calendar displayed in the pull-down menu and hence can designate the date as a start date or an end date in the analysis target period. The start date or the designated date designated at that time is displayed in the text box 44A or 44B displayed on the left side of the pull-down button 45A or 45B.

Then in the analysis mode designation screen 30, it is possible to make the schedule analysis support device 1 execute schedule analysis processing of an analysis mode, an analysis method, and an analysis target period designated by a user at that time by: designating either the past analysis mode or the future prediction mode as the analysis mode to be executed at that time and designating the analysis method to be used in the designated analysis mode in the analysis mode/analysis method designation region 31; further designating the start date and the end date in the analysis target period respectively in the analysis target period designation region 32, as stated above; and then clicking the execution button 33.

Further, in the analysis mode designation screen 30, by clicking the cancel button 34, it is possible to close the analysis mode designation screen 30 without making the schedule analysis support device 1 execute such schedule analysis processing.

(3-2) Visualization parameter designation screen and schedule analysis result display screen

FIG. 12 shows a visualization parameter designation screen 50 displayed on the display device 8 during the execution of schedule analysis processing. The visualization parameter designation screen 50 is a screen for setting the magnitudes of influences of delay factors (setting a magnification to each of the delay factors stated earlier) to a delay time of each train in each station section.

In the visualization parameter designation screen 50, character strings 51 representing the factor names of the delay factors registered in the delay factor management table 14 (FIG. 6) respectively and sliders 52 formed so as to correspond to the character strings 51 (delay factors) respectively are displayed.

Then a user can change the magnification of a delay factor corresponding to a slider 52 to a magnification corresponding to the position of the slider 52 at that time in a delay model produced by an analysis method designated in the analysis mode designation screen 30 (FIG. 11) by operating the input device 7 (FIG. 1) and moving the slider 52 corresponding to a desired delay factor in the sliders 52 associated with respective delay factors toward the left or the right. As a result, it is possible to change the magnitude of the influence of a delay factor to a delay time of each train in each station section. Here, a variable determined by the position of a slider 52 in this way is referred to as "a visualization parameter" and a value of the variable determined by the position of the slider 52 ("a magnification" stated above) is referred to as "a value of a visualization parameter" appropriately hereunder.

In the case of the present embodiment, a value (magnification) of a visualization parameter can be set steplessly in the range from "0" to "1". Specifically, a value (magnification) of a visualization parameter: can be set at "0" by locating a slider 52 at a position on the left end of the movable range; and can be set at "1" by locating the slider 52 at a position on the right end of the movable range. Further, by locating the slider 52 at an arbitrary position in the movable range, a value (magnification) of a visualization parameter can be set at a value corresponding to the position of the slider 52 in the movable range of the slider 52.

Meanwhile, FIG. 13 shows a schedule analysis result display screen 60 displayed together with the visualization parameter designation screen 50 on the display device 8. In the schedule analysis result display screen 60, a diagram 61 of a current plan schedule of a target railway in the case of setting a past analysis mode as an analysis mode or a new plan schedule of a target railway (a revised schedule in the case of an existing railway, a plan schedule newly produced in the case of a new railway, or the like) in the case of setting a future prediction mode as an analysis mode is displayed. Here, although the case of displaying the diagram 61 of a plan schedule from "6:00" to "10:00" is shown in FIG. 13, it is also acceptable to display a diagram of a plan schedule for one day.

Then in the schedule analysis result display screen 60, a magnitude of a delay time of each train in each station section calculated on the basis of a corresponding delay model, values (magnifications) of visualization parameters of respective delay factors designated by a user by using the visualization parameter designation screen 50 (FIG. 12), and past actual results of the delay factors is displayed by a color tone of a second line segment 62A represented in the manner of overlapping with a first line segment 62 representing a schedule of a train in a diagram 61 as shown in each of FIGS. 14B to 17B.

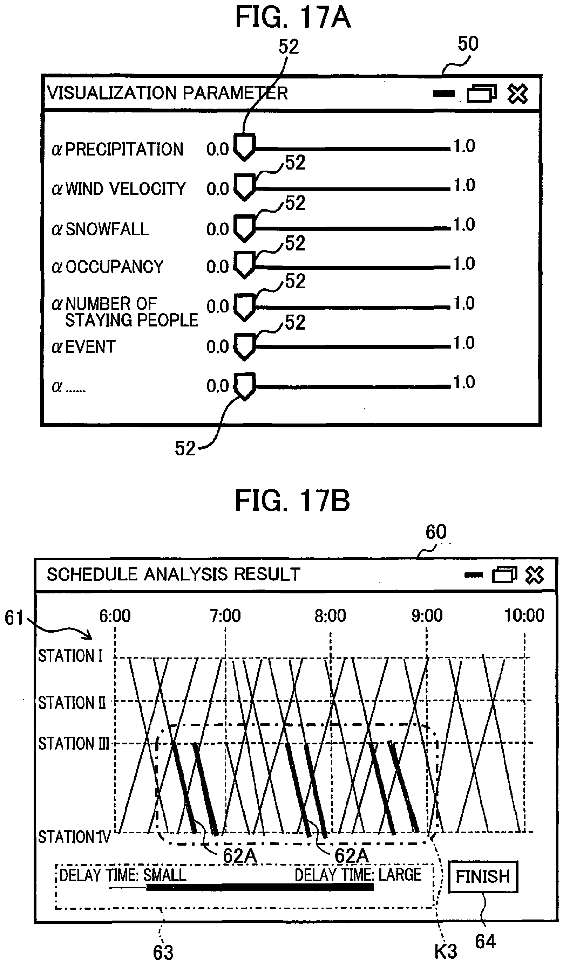

In the diagram 61, a second line segment 62A is a line segment having a length identical to a first line segment 62 in a corresponding station section and, as shown in the remark region 63, a color tone is displayed so as to deepen as a delay time increases in a station section of a train. Here, although the case of displaying a delay time of a train in a station section by five steps of color tones is shown in FIGS. 14B to 17B, a delay time may also be displayed by other steps than the five steps or a stepless color tone.

When the values (magnifications) of all the visualization parameters of all the delay factors are set at "1" in the visualization parameter designation screen 50 as shown in FIG. 14A therefore, the magnitudes of the delay times of all the trains in all the station sections in the state of being affected by all the delay factors are displayed by the color tones of the corresponding second line segments 62A in all the station sections of all the trains as shown in FIG. 14B.

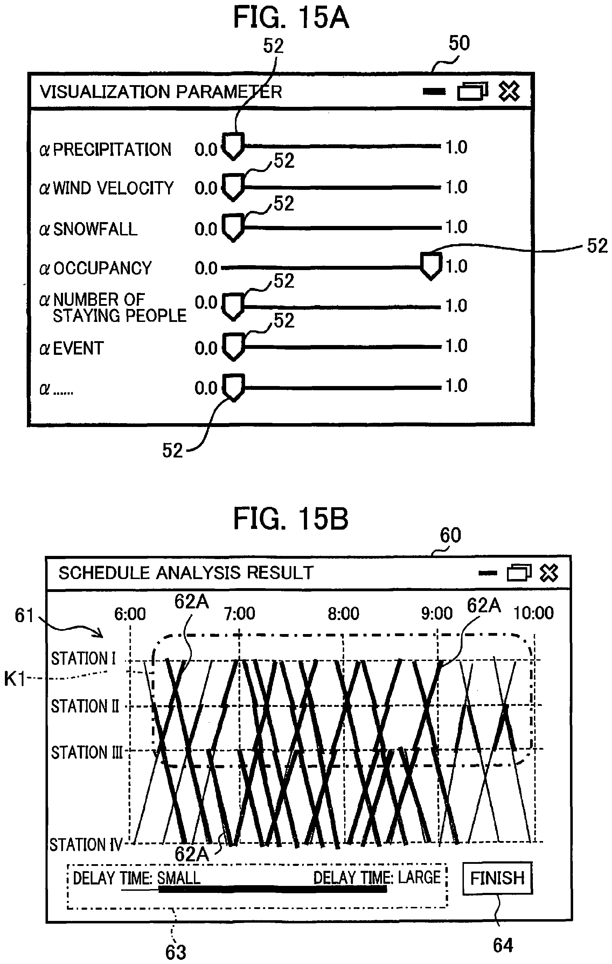

In contrast, when the value (magnification) of the visualization parameter of only one delay factor is set at "1" and the values (magnifications) of the visualization parameters of all the other delay factors are set at "0" as shown in FIG. 15A for example, the magnitudes of the delay times of all the trains in all the station sections in the state of being affected only by the delay factor the value (magnification) of the visualization parameter of which is set at "1" are displayed by the color tones of the corresponding second line segments 62A respectively as shown in FIG. 15B.

In the case of the example in FIG. 15B, it is obvious that the degree of causing the influence of passenger congestion in trains to delay the trains is high in the station section between I Station and II Station and the station section between II Station and III Station (refer to the part surrounded by the closing line K1 in the figure). A user therefore can recognize that the delays of trains in the station section between I Station and II Station and the station section between II Station and III Station can be mitigated or prevented by taking measures for eliminating congestion in trains by increasing the number of station staff at I Station and II Station and restricting the number of passengers riding the trains on the basis of the schedule analysis result display screen 60 in FIG. 15B.

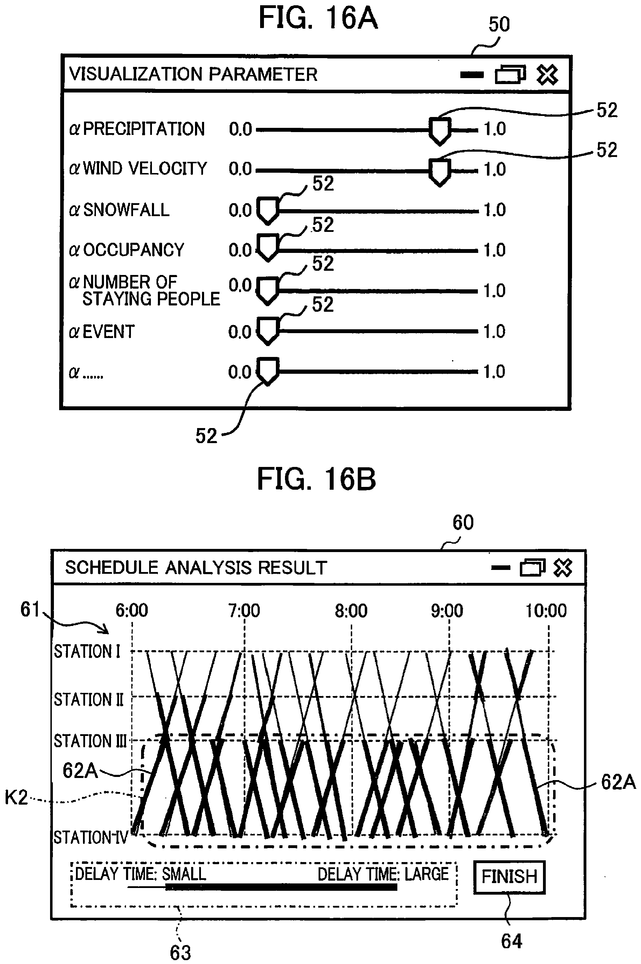

Further, when the values (magnifications) of the visualization parameters of two delay factors are set at "1" and the values (magnifications) of the visualization parameters of all the other delay factors are set at "0" as shown in FIG. 16A, the magnitudes of the delay times of the trains in the station sections affected only by the two delay factors the values (magnifications) of the visualization parameters of which are set at "1" are displayed by the color tones of the corresponding second line segments 62A in the station sections of the trains respectively as shown in FIG. 16B.

Here, in the case of the example in FIG. 16B, it is obvious that delays of trains tend to occur by the influence of rain and wind in the station section between III Station and IV Station (refer to the part surrounded by the closing line K2 in the figure) . A user therefore can recognize that the delays of trains in the station section between III Station and IV Station can be mitigated or prevented by revising the schedule to a plan schedule in which the travel speeds of trains are reduced in the station section between III Station and IV Station on the basis of the schedule analysis result display screen 60 in FIG. 16B.

Furthermore, when the values (magnifications) of the visualization parameters of all the delay factors are set at "0" as shown in FIG. 17A, the magnitudes of the delay times of the trains in the station sections influenced by neither of the delay factors are displayed by the widths and color tones of the corresponding second line segments 62A respectively as shown in FIG. 17B. The delays occurring on this occasion (refer to the part surrounded by the closing line K3 in the figure) are delays occurring regularly because of a problem of the plan schedule itself or a problem of the facility itself and hence the analysis result can be utilized for investigating a cause and revising a schedule next time.

Meanwhile, a finish button 64 is installed on the lower right of the screen in the schedule analysis result display screen 60 and, by clicking the finish button 64, it is possible to finish the schedule analysis processing stated above and close the visualization parameter designation screen 50 and the schedule analysis result display screen 60.

(3-3) Simulation setting screen

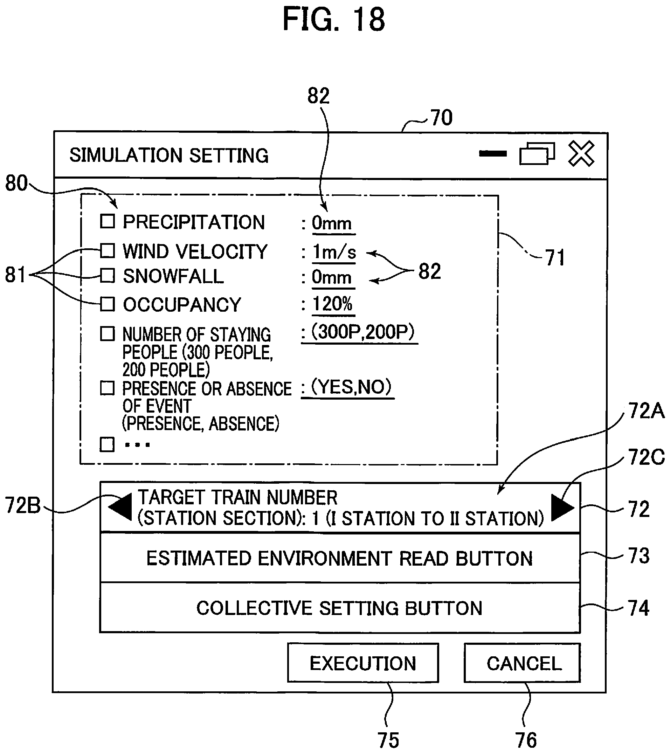

Meanwhile, FIG. 18 shows a simulation setting screen 70 displayed on the display device 8 when a future prediction mode is designated as an analysis mode in the analysis mode designation screen 30 (FIG. 11). The simulation setting screen 70 is a screen for designating a value of a visualization parameter of each of delay factors and a train and a station section that are to be analysis targets when schedule analysis processing is executed in the future prediction mode. The simulation setting screen 70 includes an assumed environment designation region 71, a target train and station section setting region 72, an assumed environment read button 73, a collective setting button 74, an execution button 75, and a cancel button 76.

Then in the assumed environment designation region 71, character strings 80 representing the names of respective delay factors registered on the delay factor management table 14 (FIG. 6), check boxes 81 formed so as to correspond to the delay factors respectively, and an assumed value setting sections 82 formed so as to correspond to the delay factors respectively are displayed.

Then in the assumed environment designation region 71, assumed values of the delay factors can be set in the corresponding assumed value setting sections 82 respectively by using the input device 7 (FIG. 1) and further the analysis of a delay time influenced only by the delay factors corresponding to check boxes 81 in which check marks (not shown in the figure) are displayed can be executed by clicking the check boxes 81 corresponding to desired one or more delay factors and displaying the check marks in the check boxes 81.

Further, the target train and station section setting region 72 is a region for setting a train and a station section to which the assumed values of the delay factors set in the assumed environment designation region 71 are to be applied. In the target train and station section setting region 72, a character string 72A representing the combination of the train umber of one train and one station section read from a plan schedule targeted at that time, a next button 72C, and a previous button 72B are displayed.

Then in the target train and station section setting region 72, it is possible to: switch the combination of a train number and a station section represented by a character string 72A at that time to the combination of a next train number and a next station section read from a plan schedule by clicking the next button 72C; and switch the combination of a train number and a station section represented by a character string 72A at that time to the combination of a last train number and a last station section read from a plan schedule by clicking the previous button 72B.

As a result, a user, in the simulation setting screen 70: displays a character string 72A representing the combination of one train number and one station section in the target train and station section setting region 72; successively sets assumed values of delay factors respectively in the assumed environment designation region 71; hence can set the assumed values of the delay factors in the station section of the train of the train number; successively sets assumed values of delay factors for all other trains and station sections respectively while the next button 72B and the previous button 72C are operated; and thus can set a simulation condition of a delay time of each of the trains in each of the station sections in a new plan schedule.

Further, in the simulation setting screen 70, by clicking the assumed environment read button 73, it is possible to: read a file of the previously produced assumed values of delay factors; and apply the assumed values of the delay factors prescribed in the file to the combination of a train number and a station section displayed at that time in the target train and station section setting region 72. On this occasion, the assumed values of the delay factors prescribed in the file are displayed as the assumed values of the delay factors in the assumed environment designation region 71.

Furthermore, in the simulation setting screen 70, by clicking the collective setting button 74, it is also possible to: read a file, which has previously been produced and registered, of assumed values of delay factors in each station section of each train in a plan schedule targeted at that time; and collectively set up the assumed values of the delay factors in each of the station sections of each of the trains prescribed in the file as the simulation condition in the simulation this time.

Then, in the simulation setting screen 70, by clicking the execution button 75 after setting up the assumed values in each of the station sections of each of the trains in the new plan schedule targeted at that time as a simulation condition as stated above, it is possible to make the schedule analysis support device 1 execute a simulation of predicting a delay time of the train in the station section when the trains are operated under the new plan schedule on the basis of the simulation condition. Further, on this occasion, a user can set up the value (magnification) of a visualization parameter of each of the delay factors by using the visualization parameter designation screen 50 stated above in reference to FIG. 12 and a simulation result corresponding to the set up at that time is displayed in the schedule analysis result display screen 60 as stated earlier in reference to FIGS. 14B to 17B.

Moreover, in the simulation setting screen 70, by clicking the cancel button 76, it is possible to: discard various settings set up heretofore by using the simulation setting screen 70; and close the simulation setting screen 70.


(4) Processing on schedule analysis support function


(4-1) Flow of processing on schedule analysis support function


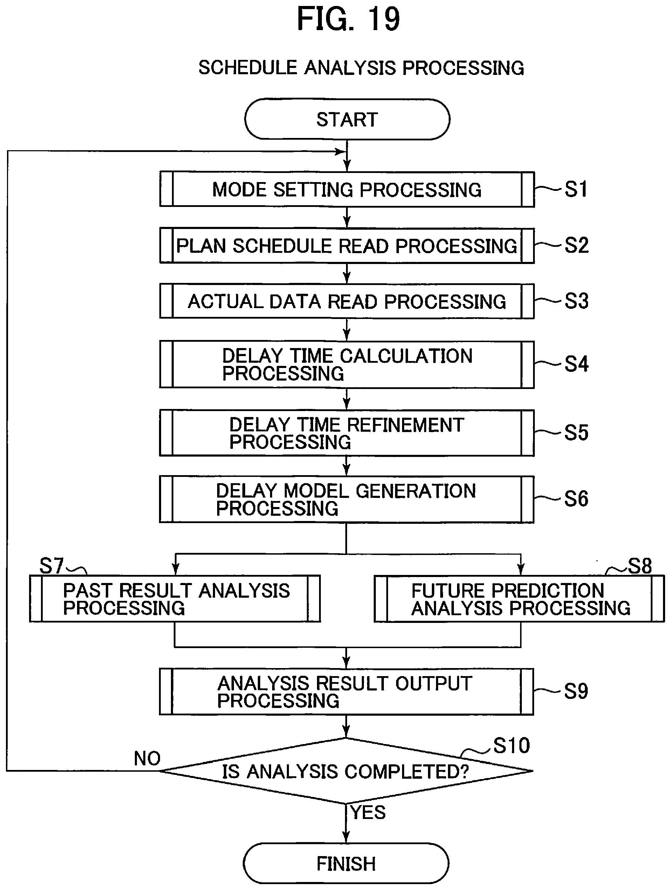

FIG. 19 shows a flow of processing executed by a schedule analysis support device 1 in reference to a schedule analysis support function according to the present embodiment. In the schedule analysis support device 1, in accordance with a predetermined operation of a user, firstly the mode setting unit 21 (FIG. 1) displays the analysis mode designation screen 30 (FIG. 11) on the display device 8 and sets up an analysis mode, an analysis method, and an analysis period designated by the user by using the analysis mode designation screen 30 as the operation condition of the schedule analysis support device 1 (S1).

Successively, the plan schedule read unit 22 (FIG. 1) reads a plan schedule to be targeted at that time from among the plan schedules stored in the plan schedule management table 10 (FIG. 2) (S2). Further, the actual data read unit 23 (FIG. 1): reads an actual schedule of each train during an analysis target period designated by the user by using the analysis mode designation screen 30 from the actual schedule management table 11 (FIG. 3); and reads actual values of delay factors in each of station sections of the train during the analysis target period from the delay-factor-specific result management table 16 (FIG. 8) (S3).

Successively, the delay time calculation unit 24 calculates a delay time of the train in the station section in the plan schedule on the basis of the plan schedule that is read from the plan schedule management table 10 by the plan schedule read unit 22, an actual schedule of the train during the analysis target period read from the actual schedule management table 11 by the actual data read unit 23, and the actual values of the delay factors in the station section of the train during the analysis target period read from the delay-factor-specific result management table 16 by the actual data read unit 23 (S4).

Further, the delay time refinement unit 25 (FIG. 1) calculates a delay time of the train in the station section during the analysis target period excluding the influence of secondary delay while the schedule restrictions of the train registered in the schedule restriction management table 13 (FIG. 5) are taken into consideration (S5) .

Successively, the delay model generation unit 26 (FIG. 1) generates a delay model in the station section of the train in the analysis mode, the analysis method, and the analysis target period designated by the user by using the analysis mode designation screen 30 (S6).

Then when the analysis mode designated by the user in the analysis mode designation screen 30 is a past analysis mode, successively the past result analysis unit 27 (FIG. 1) calculates a delay time of the train in the station section by using the corresponding delay model generated by the delay model generation unit 26 (S7).

Otherwise, when the analysis mode designated by the user in the analysis mode designation screen 30 is a future prediction mode, the future prediction analysis unit 28 (FIG. 1) simulates (predicts) a delay time of the train in the station section by using the assumed values of the delay factors set by the user by using the simulation setting screen 70 (FIG. 18) and the corresponding delay model (S8).

Then, when the processing of the step S7 by the past result analysis unit 27 or the processing of the step S8 by the future prediction analysis unit 28 is finished, the analysis result output unit 29 (FIG. 1) displays the schedule analysis result display screen 60 in which the magnitude of a delay time of the train in the station section calculated by the past result analysis unit 27 or the future prediction analysis unit 28 is expressed by a color tone of a corresponding second line segment 62A in the diagram 61 as shown in FIGS. 14 to 17 on the display device 8. Further, the analysis result output unit 29, when the value (magnification) of the visualization parameter of one of delay factors is changed in the visualization parameter designation screen 50 (FIG. 12): makes the past result analysis unit 27 or the future prediction analysis unit 28 recalculate a delay time of each train in each station section in response to the change; and updates the diagram 61 in the schedule analysis result display screen 60 displayed on the display device 8 at that time on the basis of the calculation result (S9) .

Successively, the processing returns to the step S1 when the user designates a next plan schedule and designates the execution of new schedule analysis processing (NO at S10) and then the processing of the step S1 and later is executed similarly to the above. On the other hand, when the user designates the finish of the schedule analysis processing after the finish of the step S9 (YES at S10), the schedule analysis processing finishes.

(4-2) Mode setting processing

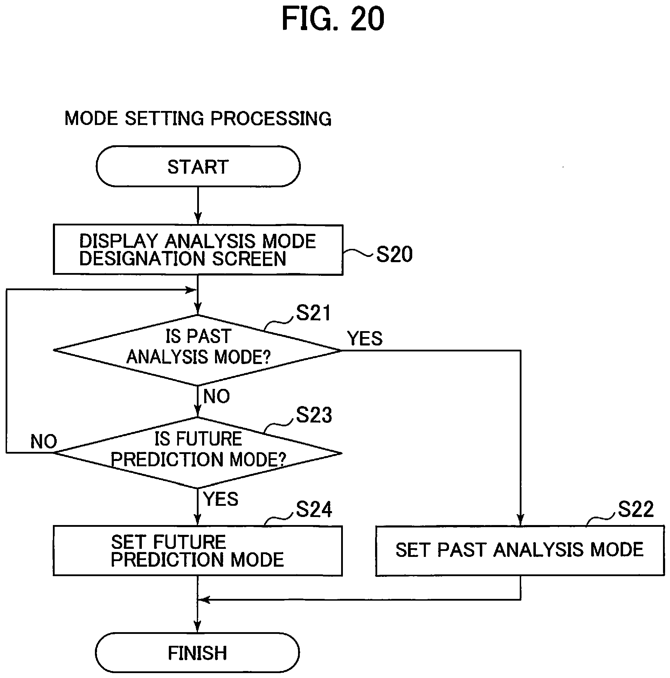

FIG. 20 shows a specific processing content of processing (the processing is hereunder referred to as mode setting processing) executed by the mode setting unit 21 at the step S1 in the schedule analysis processing stated above in reference to FIG. 19. The mode setting unit 21 starts the mode setting processing shown in FIG. 20 in accordance with user operation and firstly displays the analysis mode designation screen 30 stated above in reference to FIG. 11 on the display device 8 (S20).

Successively, the mode setting unit 21 waits for either of a past analysis mode and a future prediction mode being selected as the analysis mode of the schedule analysis processing executed at that time in the analysis mode designation screen 30 (S21, S22).

Then, the mode setting unit 21, when the past analysis mode is selected as the analysis mode soon (YES at S21), sets up the analysis mode of the schedule analysis support device 1 to the past analysis mode (S22), successively calls the plan schedule read unit 22, and then finishes the mode setting processing.

On the other hand, the mode setting unit, when the future prediction mode is selected as the analysis mode (YES at S23), sets up the analysis mode of the schedule analysis support device 1 to the future prediction mode (S24), successively calls the plan schedule read unit 22, and then finishes the mode setting processing.

(4-3) Plan schedule read processing

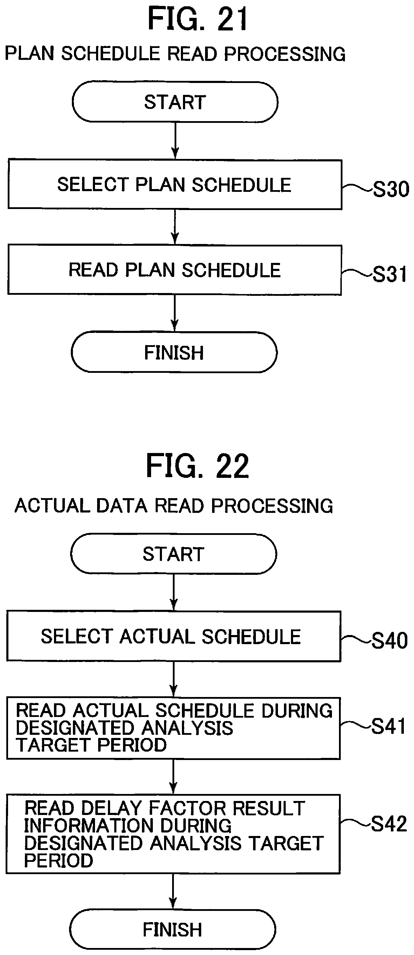

FIG. 21 shows a specific processing content of processing (the processing is hereunder referred to as plan schedule read processing) executed by the plan schedule read unit 22 at the step S2 in the schedule analysis processing stated above in reference to FIG. 19. The plan schedule read unit 22 reads data of a plan schedule from the plan schedule management table 10 (FIG. 2) in accordance with the processing procedure shown in FIG. 21.

Actually, the plan schedule read unit 22, when called by the mode setting unit 21, starts plan schedule read processing shown in FIG. 21 and firstly selects a plan schedule to be an analysis target at that time (S30). Here, the plan schedule of the analysis target is a plan schedule designated by a user in advance.

Successively, the plan schedule read unit 22 reads the data of the plan schedule selected at the step S30 from the plan schedule management table 10 (S31), successively calls the actual data read unit 23, and then finishes the plan schedule read processing.

(4-4) Actual data read processing

FIG. 22 shows a specific processing content of processing (the processing is hereunder referred to as actual data read processing) executed by the actual data read unit 23 at the step S3 in the schedule analysis processing stated above in reference to FIG. 19. The actual data read unit 23 reads necessary information (actual data) from the actual schedule management table 11 (FIG. 3) and the delay-factor-specific result management table 16 (FIG. 8) in accordance with the processing procedure shown in FIG. 22.

Actually, the actual data read unit 23, when called by the plan schedule read unit 22 as stated above, starts the actual data read processing shown in FIG. 22 and firstly selects an actual schedule to be targeted at that time (S40).

Specifically, the actual data read unit 23 selects an actual schedule corresponding to the plan schedule selected by the plan schedule read unit at the step S30 in the plan schedule read processing stated above in reference to FIG. 21 at the step S40.

Successively, the actual data read unit 23 reads all the data of all the trains in the actual schedule during an analysis target period designated by the user by using the analysis mode designation screen 30 in the actual schedule selected at the step S40 from the actual schedule management table 11 (S41).

Further, the actual data read unit 23 reads the data of the actual values of all the delay factors during the analysis target period from the delay-factor-specific result management table 16 (S42). Then successively, the actual data read unit 23 calls the delay time calculation unit 24 and then finishes the actual data read processing.

(4-5) Delay time calculation processing

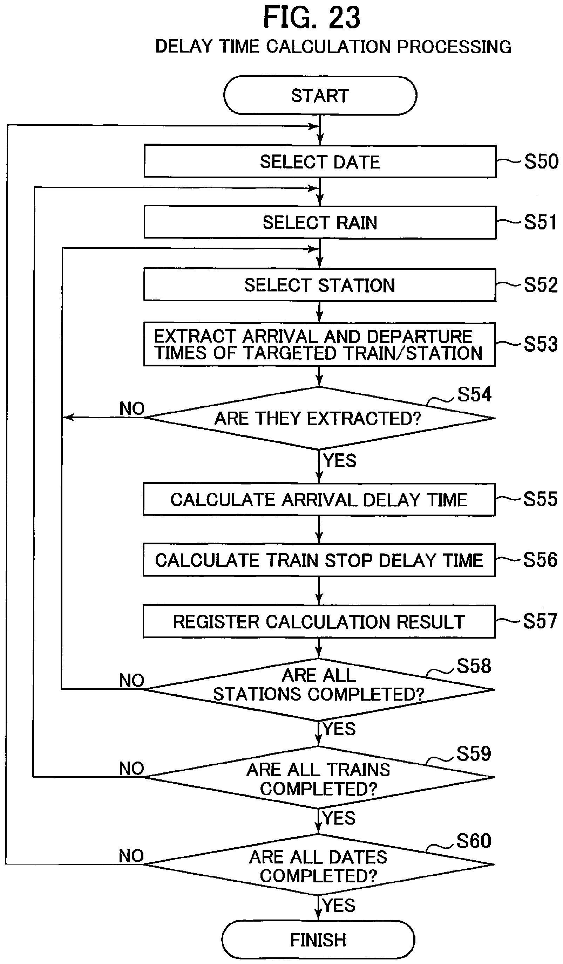

FIG. 23 shows a specific processing content of processing (this processing is hereunder referred to as delay time calculation processing) executed by the delay time calculation unit 24 at the step S4 in the schedule analysis processing stated above in reference to FIG. 19. The delay time calculation unit 24 produces the train delay time management table 12 stated above in reference to FIG. 4 in accordance with the processing procedure shown in FIG. 23.

Actually, the delay time calculation unit 24, when called by the actual data read unit 23, starts the delay time calculation processing sown in FIG. 23 and firstly selects one of unprocessed days during an analysis target period designated by a user by using the analysis mode designation screen 30 (S50) . Further, the delay time calculation unit 24 selects one of unprocessed trains from among trains to which train numbers are given (S51) and further selects one of unprocessed stations from among the stations on a target railway (S52).

Successively, the delay time calculation unit 24 extracts an arrival time at the station selected at the step S52 and a departure time from the station (those are collectively referred to as arrival and departure times hereunder) of the train selected at the step S51 on the day selected at the step S50 from a plan schedule acquired by the plan schedule read unit 22 at the step S2 in the schedule analysis processing (FIG. 19) (S53). Further, the delay time calculation unit 24 successively judges whether or not such arrival and departure times have been able to be extracted (S54).

Here, when the type of the train selected at the step S51 is a special train such as "rapid" or "express" and the train does not stop at the station selected at the step S52 for example, a negative result (NO at S54) is given at the step S54. When the schedule of a train does not exist originally in a plan schedule too like when a train selected at the step S51 is an extra train, a negative result (NO at S54) is given at the step S54. Thus, the delay time calculation unit 24 returns to the step S52 at that time.

On the other hand, the delay time calculation unit 24, when it receives a positive result (YES at S54) in the judgment at the step S54, calculates a difference between an arrival time acquired at the step S53 and an arrival time at the station of the train specified in the plan schedule as an arrival delay time (S55). Further, the delay time calculation unit 24 calculates a difference between a train stop time at the station of the train calculated as a difference between an arrival time and a departure time at the station of the train acquired at the step S53 and a train stop time at the station of the train in the plan schedule as a train stop delay time (S56).

Moreover, the delay time calculation unit 24 stores an arrival delay time calculated at the step S55 and a train stop delay time calculated at the step S56 into the corresponding arrival delay time column 12DAA (FIG. 4) and the corresponding train stop delay time column 12DAB (FIG. 4) respectively in the train delay time management table 12 (S57). Here, the train delay time management table 12 is a table produced by the delay time calculation unit 24 in the state of copying only the entire information of the train number column 10A, the train type column 10B, and the up-or-down classification column 10C on each of the rows of the plan schedule management table 10 into the respective corresponding columns (the train number column 12A, the train type column 12B, and the up-or-down classification column 12C) and blanking the section-specific delay time column 12D (FIG. 4) when the step S57 of the delay time calculation processing is executed originally on the basis of a plan schedule read by the plan schedule read unit 22 at the step S2 in the schedule analysis processing stated above in reference to FIG. 19.

Successively, the delay time calculation unit 24, with regard to the train selected at the step S51 on the day selected at the step S50, judges whether or not the execution of the processing of the step S53 and later to all the stations on the target railway is finished (S58). Then the delay time calculation unit 24, when it receives a negative result (NO at S58) in the judgment, returns to the step S52 and then repeats the processing of the steps S52 to S58 while the station selected at the step S52 is switched to another unprocessed station sequentially.

Then the delay time calculation unit 24, when it receives a positive result at the step S58 (YES at S58) by finishing the execution of the processing of the step S53 and later to all the stations on the target railway with regard to the train selected at the step S51 soon, judges whether or not the execution of the processing of the steps S52 to S58 to all the trains to which the train numbers are given with regard to the day selected at the step S50 is finished (S59).

The delay time calculation unit 24, when it receives a negative result (NO at S59) in the judgment, returns to the step S51 and then repeats the processing of the steps S51 to S59 while the train selected at the step S51 is switched to another unprocessed train sequentially.

Then the delay time calculation unit 24, when it receives a positive result at the step S59 (YES at S59) by finishing the execution of the processing of the steps S52 to S58 to all the trains to which the train numbers are given with regard to the day selected at the step S50 soon, judges whether or not the execution of the processing of the steps S51 to S59 with regard to all the days during the analysis target period is finished (S60).

The delay time calculation unit 24, when it receives a negative result (NO at S60) in the judgment, returns to the step S50 and then repeats the processing of the steps S50 to S60 while the day selected at the step S50 is switched to another unprocessed day sequentially. Then the delay time calculation unit 24, when it receives a positive result at the step S60 (YES at S60) by finishing the execution of the processing of the steps S51 to S59 with regard to all the days during the designated analysis target period soon, calls the delay time refinement unit 25 and then finishes the delay time calculation processing.

(4-6) Delay time refinement processing

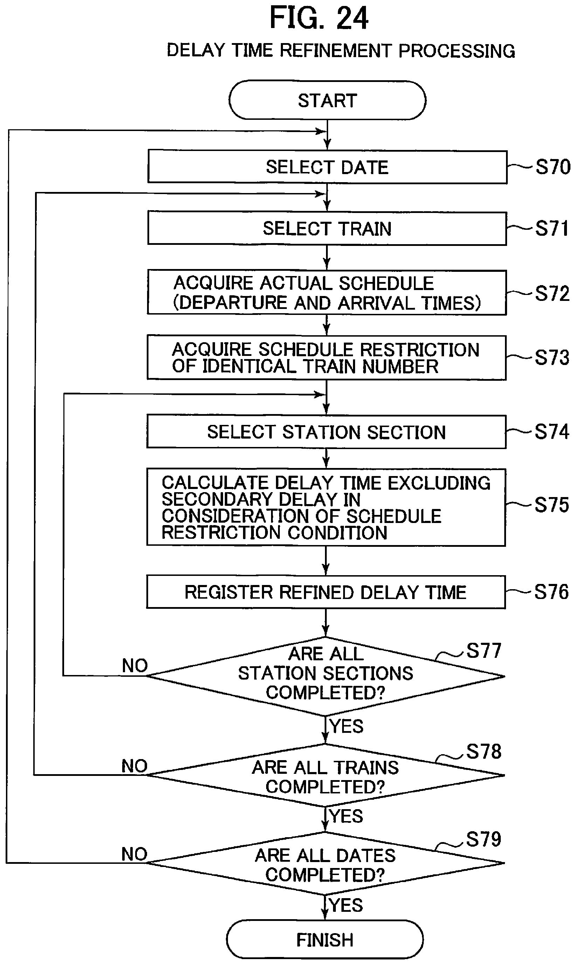

FIG. 24 shows a specific processing content of processing (the processing is hereunder referred to as delay time refinement processing) executed by the delay time refinement unit 25 at the step S5 in the schedule analysis processing stated above in reference to FIG. 19. The delay time refinement unit 25 produces the post-refinement train delay time management table 15 (FIG. 7) stated above in reference to FIG. 7 in accordance with the processing procedure shown in FIG. 24.

Actually, the delay time refinement unit 25, when called by the delay time calculation unit 24, starts the delay time refinement processing shown in FIG. 24 and firstly selects one of the unprocessed days during an analysis target period is selected (S70). Further, the delay time refinement unit 25 selects one of the unprocessed trains from among the trains to which train numbers are given (S71).

Successively, the delay time refinement unit 25 extracts and thus acquires the actual schedule (an arrival time at each of stations and a departure time from each of stations) of the train selected at the step S71 on the day selected at the step S70 from the actual schedule read from the actual schedule management table 11 (FIG. 3) by the actual data read unit 23 at the step S3 in the schedule analysis processing stated above in reference to FIG. 19 (S72). Further, the delay time refinement unit 25 acquires the schedule restrictions given to the train having the train number selected at the step S71 from the schedule restriction management table 13 (FIG. 5) (S73).

Successively, the delay time refinement unit 25: selects one of unprocessed station sections from among the station sections on a target railway (S74); calculates an arrival delay time and a train stop delay time excluding secondary delay respectively while the schedule restrictions acquired at the step S73 are taken into consideration in the station section of the train selected at the step S71 (S75); and registers the calculation result in the post-refinement train delay time management table 15 (S76).

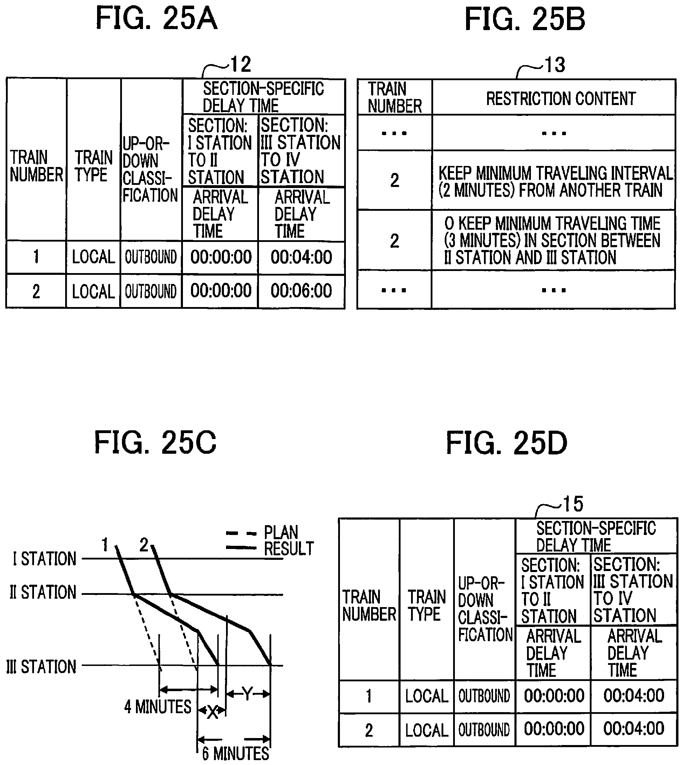

For example, a case where an arrival delay time of "III Station" in the station section of "II Station to III Station" of the train having the train number of "1" is "00:04:00" and an arrival delay time of "III Station" in the station section of "II Station to III Station" of the train having the train number of "2" is "00:06:00" as shown in FIG. 25A and the schedule restriction of "to keep a minimum traveling interval (2 minutes) from another train" is given to the train having the train number of "2" as shown in FIG. 25B is considered.

On this occasion, as shown in FIG. 25C, since the time shown with "X" in the figure is 2 minutes of the minimum traveling interval in the delay of 6 minutes of the train ("2√" in the figure) having the train number of "2", the delay time of the train having the train number of "2" excluding secondary delay in consideration of such schedule restriction (in other words, a pure delay time ("Y" in the figure) of the train having the train number of "2" alone excluding the delay of the preceding train) is calculated as 4 minutes. Then the delay time refinement unit 25, as shown in FIG. 25D, stores the delay time (here, 4 minutes) thus calculated in the corresponding arrival delay time column 15DAA (FIG. 7) in the post-refinement train delay time management table 15. Further, the delay time refinement unit 25 calculates a train stop delay time similarly to that and stores the calculated train stop delay time in the corresponding train stop delay time column 15DAB (FIG. 7) in the post-refinement train delay time management table 15.

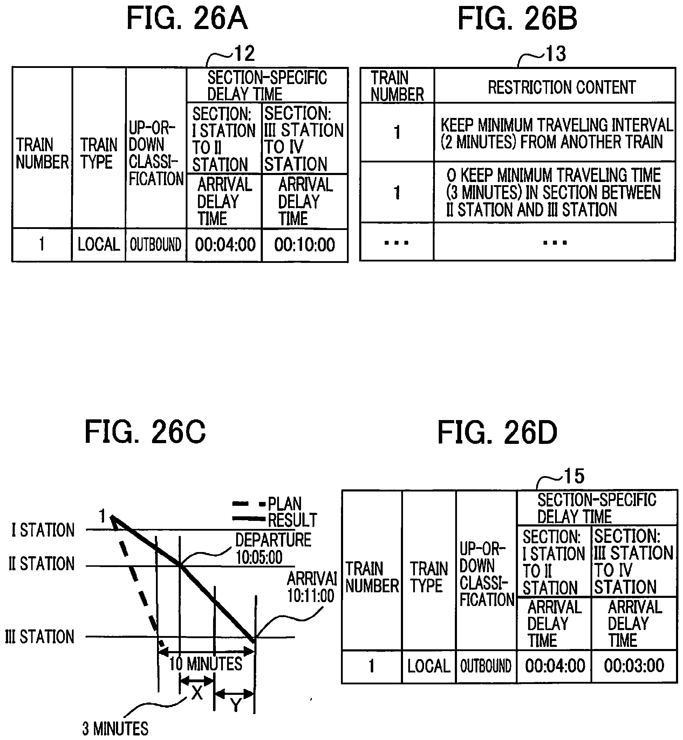

Meanwhile, for example, a case where an arrival delay time at "II Station" in the station section of "I Station to II Station" is "00:04:00" and an arrival delay time at "III Station" in the station section of "II Station to III Station" is "00: 10: 00" of the train having the train number of "1" as shown in FIG. 26A and the schedule restriction of "to keep a minimum traveling time (3 minutes) between II Station and III Station" is given to the train having the train number of "1" as shown in FIG. 26B is considered.

On this occasion, as shown in FIG. 26C, if an arrival time at II Station is "10: 05: 00" and an arrival time at III Station is "10: 11: 00" in the train having the train number of "1" for example, since the time shown by "X" in the figure is 3 minutes of the minimum traveling time, the delay time of the train having the train number of "1" excluding secondary delay in consideration of such schedule restriction (in other words, a pure delay time ("Y" in the figure) of the train having the train number of "1" alone excluding the delay of a preceding train) can be calculated as 3 minutes. Then, the delay time refinement unit 25, as shown in FIG. 26D, stores the delay time thus calculated (here, 3 minutes) in the corresponding arrival delay timed column 15DAA in the post-refinement train delay time management table 15. Further, the delay time refinement unit 25 calculates a train stop delay time similarly to that and stores the calculated train stop delay time in the corresponding train stop delay time column 15DAB (FIG. 7) in the post-refinement train delay time management table 15.

Here, the post-refinement train delay time management table 15 is a table produced by the delay time refinement unit 25 in the state of: copying only the entire information of the train number column 12A, the train type column 12B, and the up-or-down classification column 12C in each of the rows of the train delay time management table 12 stated above in reference to FIG. 4 into the respective corresponding columns (the train number column 15A, the train type column 15B, and the up-or-down classification column 15C); and blanking the section-specific delay time column 15D (FIG. 7) when the step S76 of the delay time refinement processing is executed originally.

Successively, the delay time refinement unit 25, with respect to the train selected at the step S71 on the day selected at the step S70, judges whether or not the execution of the processing of the step S72 and later to all the station sections on the target railway is finished (S77). Then the delay time refinement unit 25, when it receives a negative result (NO at S77) in the judgment, returns to the step S74 and then repeats the processing of the steps S74 to S77 while the station selected at the step S74 is switched to another unprocessed station sequentially.

Then the delay time refinement unit 25, when it receives a positive result at the step S77 (YES at S77) by finishing the execution of the processing of the step S75 and later to all the station sections on the target railway with regard to the train selected at the step S71 soon, judges whether or not the execution of the processing of the steps S72 to S77 to all the trains to which the train numbers are given with regard to the day selected at the step S70 is finished (S78).

The delay time refinement unit 25, when it receives a negative result (NO at S78) in the judgment, returns to the step S71 and then repeats the processing of the steps S71 to S78 while the train selected at the step S71 is switched to another unprocessed train sequentially.

Then the delay time refinement unit 25, when it receives a positive result at the step S78 (YES at S78) by finishing the execution of the processing of the steps S72 to S77 to all the trains to which the train numbers are given with regard to the day selected at the step S70 soon, judges whether or not the execution of the processing of the steps S71 to S78 with regard to all the days during the designated analysis target period is finished (S79).

The delay time refinement unit 25, when it receives a negative result (NO at S79) in the judgment, returns to the step S70 and then repeats the processing of the steps S70 to S79 while the day selected at the step S70 is switched to another unprocessed day sequentially. Then the delay time refinement unit 25, when it receives a positive result at the step S79 (YES at S79) by finishing the execution of the processing of the steps S71 to S78 with regard to all the days during the analysis target period soon, calls the delay model generation unit 26 and then finishes the delay time refinement processing.

(4-7) Delay model generation processing

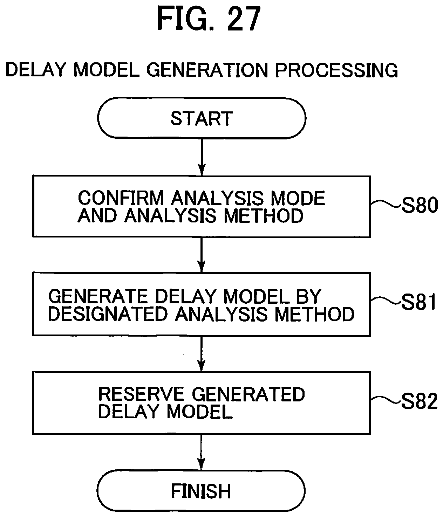

FIG. 27 shows a specific processing content of processing (the processing is hereunder referred to as delay model generation processing) executed by the delay model generation unit 26 at the step S6 in the schedule analysis processing stated above in reference to FIG. 19. The delay model generation unit 26 generates a delay model in each station section of each train in a plan schedule targeted at that time in accordance with the processing procedure shown in FIG. 27.

Actually, the delay model generation unit 26, when called by the delay time refinement unit 25, starts the delay model generation processing shown in FIG. 27 and firstly confirms an analysis mode and an analysis method designated by a user in the analysis mode designation screen 30 (S80).

Successively, the delay model generation unit 26, on the basis of the confirmation result at the step S80, generates a delay model by: using information stored in the post-refinement train delay time management table 15 (FIG. 7) (the information is hereunder referred to as post-refinement train delay time information) corresponding to an analysis target period and actual values of the delay factors in each station section on each day during the analysis target period read from the delay-factor-specific result management table 16 (FIG. 8) by the actual data read unit 23 at the step S3 of the schedule analysis processing in FIG. 19 as inputs; and executing an analysis method designated by a user (S81). On this occasion, the delay model generation unit 26 generates a delay model in each of the station sections of each of the trains in the plan schedule.

Successively, the delay model generation unit 26 stores the generated delay models in the delay model management table 18 (FIG. 10) (S82). When the analysis method designated by a user is a multiple regression analysis method for example, the terms "$a_1$", "$a_2$", "$a_3$", ····· that are the coefficients of respective delay factors in the expression (1) stated earlier are stored in the delay model management table 18. Here, the delay model management table 18 is a table produced by the delay model generation unit 26 in the state of blanking the delay factor coefficient column 18E (FIG. 10) when the step S82 of the delay model generation processing is executed.

Then the delay model generation unit 26 successively: calls the past result analysis unit 27 when the analysis mode designated by a user in the analysis mode designation screen 30 is a past analysis mode; calls the future prediction analysis unit 28 when the analysis mode designated by a user in the analysis mode designation screen 30 is a future prediction mode; and then finishes the delay model generation processing.

(4-8) Past result analysis processing

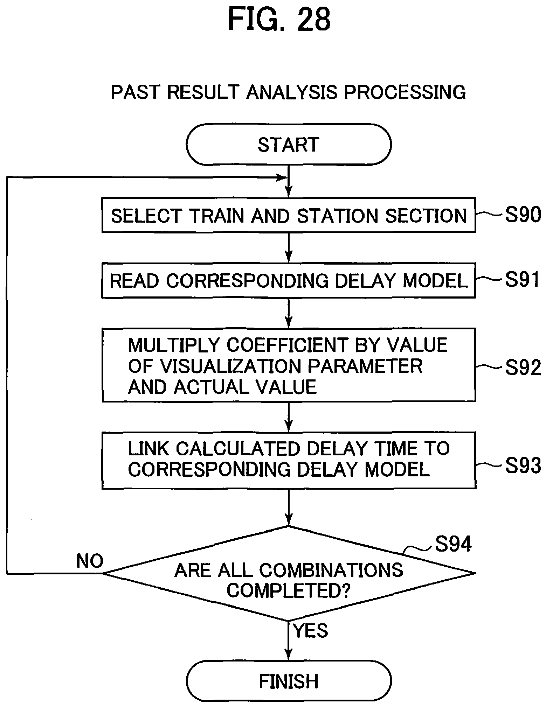

FIG. 28 shows a specific processing content of processing (the processing is hereunder referred to as past result analysis processing) executed by the past result analysis unit 27 at the step S7 in the schedule analysis processing stated above in reference to FIG. 19. The past result analysis unit 27, in accordance to the processing procedure shown in FIG. 28, calculates a delay time of each train in each station section corresponding to the values (magnifications) of the visualization parameters of respective delay factors given by a user in the visualization parameter designation screen 50 (FIG. 12).

Actually, the past result analysis unit 27, when called by the delay model generation section 26, starts the past result analysis processing shown in FIG. 28 and firstly selects one station section of one train (a train to which a train number is given) in a plan schedule of an analysis target (S90). Further, the past result analysis unit 27 reads a delay model corresponding to the combination of the train and the station section selected at the step S90 from the delay model management table 18 (FIG. 10) (S91).

Successively, the past result analysis unit 27 multiplies the coefficients of the delay factors in the delay model read at the step S91 by the values (magnifications) of the visualization parameters given to the delay factors in the visualization parameter designation screen 50 at that time and the actual values of the corresponding delay factors read from the delay-factor-specific result management table 16 (FIG. 8) by the actual data read unit 23 at the step S3 in the schedule analysis processing (FIG. 19) (S92). As a result, a delay time corresponding to the values (magnifications) of the corresponding visualization parameters in the station section selected at the step S90 of the train selected at the step S90 can be calculated by using the corresponding delay model.

Here, since the initial value of a visualization parameter is "1", "1" is applied as the value (magnification) of a visualization parameter at the stage of the step S7 in the schedule analysis processing stated above in reference to FIG. 19.

Further, when the analysis target period is not only one day but lasts for several days, at the step S92, the past result analysis unit 27, with respect to each delay factor, calculates the average value of the actual values of the delay factor during the several days and multiplies the coefficient of the delay factor by the calculated average value and the value (magnification) of the visualization parameter given to the delay factor at that time. As a result, it is possible to calculate an average delay time during the analysis target period corresponding to the values of the corresponding visualization parameters in the station section selected at the step S90 of the train selected at the step S90 by using the corresponding delay model by using the corresponding delay model.

Successively, the past result analysis unit 27 links a delay time calculated at the step S92 to a corresponding delay model (S93). Further, the past result analysis unit 27 successively judges whether or not the execution of the processing of the steps S91 to S93 with respect to the combinations of all the station sections of all the trains in the plan schedule of the analysis target is finished (S94).

Then the past result analysis unit 27, when it receives a negative result (NO at S94) in the judgment, returns to the step S90 and then repeats the processing of the steps S90 to S94 while the combination of the train and the station section selected at the step S90 is switched to another unprocessed combination sequentially.

Then, the past result analysis unit 27, when it receives a positive result (YES at S94) at the step S94 by finishing the execution of the processing of the steps S91 to S93 with regard to the combinations of all the trains and all the station sections in the plan schedule of the analysis target soon, calls the analysis result output unit 29 and then finishes the past result analysis processing.

(4-9) Future prediction analysis processing

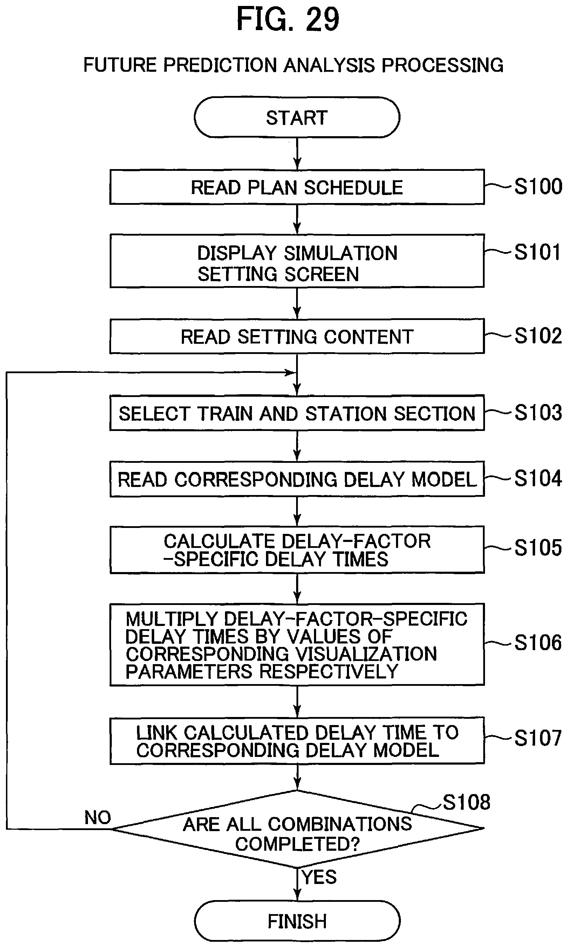

FIG. 29 shows a specific processing content of processing (the processing is hereunder referred to as future prediction analysis processing) executed by the future prediction analysis unit 28 at the step S8 in the schedule analysis processing stated above in reference to FIG. 19. The future prediction analysis unit 28 calculates a delay time of each train in each station section in a new plan schedule and a predicted value of a delay time of each train in each station section corresponding to the values (magnifications) of the visualization parameters of respective delay factors given by a user in the visualization parameter designation screen 50 (FIG. 12) in accordance with the processing procedure shown in FIG. 29.

Actually, the future prediction analysis unit 28, when called by the delay model generation unit 26, starts the future prediction analysis processing shown in FIG. 29 and firstly reads a new plan schedule of an analysis target (for example, a new plan schedule to be revised when the target railway is an existing railway or a new plan schedule when the target railway is a new railway) (S100). Further, the future prediction analysis unit 28 displays the simulation setting screen 70 stated above in reference to FIG. 18 on the display device 8 (S101).

Then, the future prediction analysis unit 28 successively, when a user clicks the execution button 75 (FIG. 18) after the setting of all the assumed values of the delay factors in each station section of each train in a new plan schedule of the analysis target is finished, reads the assumed values of the delay factors in the station section of the train given by using the simulation setting screen 70 at that time (S102) and then selects one station section of one train in the plan schedule read at step S100 (S103).

Successively, the future prediction analysis unit 28 reads the delay model corresponding to the station section selected at the step S103 of the train selected at the step S103 from the delay model management table 18 (FIG. 10) (S104). Here, when the plan schedule read at the step S100 is a plan schedule of a railway that cannot generate a delay model based on an actual result of the railway such as a plan schedule of a new railway, the future prediction analysis unit 28 read a delay model calculated for another train travelling during an identical or close time zone in an identical or similar station section at the step S104. It is also possible to make a user designate such a delay model on such an occasion.

Further, the future prediction analysis unit 28 calculates the predicted values of the delay times of respective delay factors in the station section of the train selected at the step S103 by applying the assumed values of the delay factors acquired at the step S102 to the delay model acquired at the step S104 (S105).

Further, the future prediction analysis unit 28: multiplies the delay times of the delay factors calculated at the step S105 by the values (magnifications) of the corresponding visualization parameters; and then adds up the multiplication results (S106). Here, since the initial value of a visualization parameter is "1" as stated above, the delay times of the delay factors are multiplied by "1" respectively at the stage of the step S9 in the schedule analysis processing stated above in reference to FIG. 19. Then, a predicted value of a delay time of the train in the station section selected at the step S103 is calculated by adding up the multiplication results.

Successively, the future prediction analysis unit 28 links the predicted value of the delay time calculated at the step S106 to a corresponding delay model (S107). Further, the future prediction analysis unit 28 then judges whether or not the execution of the processing of the steps S104 to S107 to the combination of the train and the station section to be targeted in the plan schedule of the analysis target is finished (S108).

Then the future prediction analysis unit 28, when it receives a negative result (NO at S108) in the judgment, returns to the step S103 and then repeats the processing of the steps S103 to S108 while the combination of the train and the station section selected at the step S103 is switched to another unprocessed combination sequentially.

Then the future prediction analysis unit 28, when it receives a positive result (YES at S108) at the step S108 by finishing the execution of the processing of the steps S104 to S107 to all the combinations of the trains and the station sections to be targeted in the plan schedule of the analysis target soon, calls the analysis result output unit 29 and then finishes the future prediction analysis processing.

(4-10) Analysis result output processing

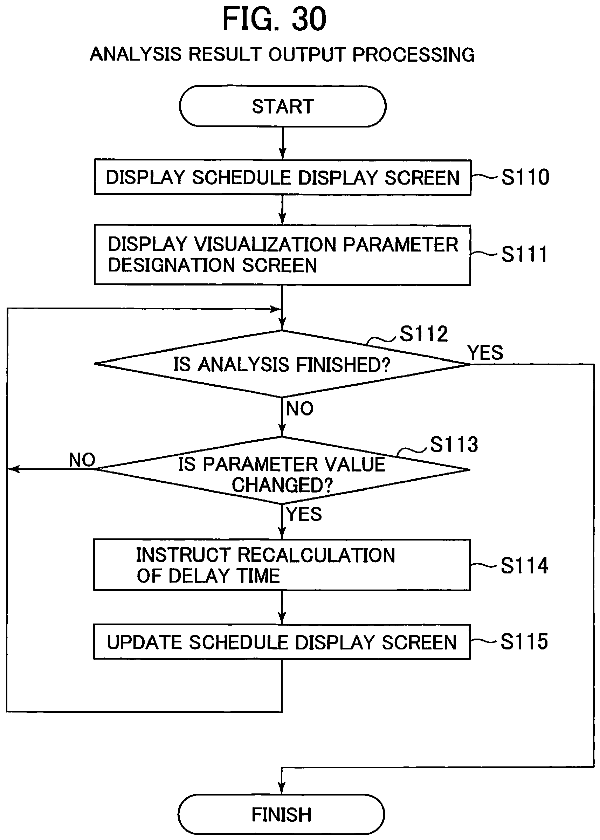

FIG. 30 shows a specific processing content of processing (the processing is hereunder referred to as analysis result output processing) executed by the analysis result output unit 29 at the step S9 in the schedule analysis processing stated above in reference to FIG. 19. The analysis result output unit 29: displays the schedule analysis result display screen 60 (FIG. 13) based on the processing result of the past result analysis processing (FIG. 28) executed by the past result analysis unit 27 or the processing result of the future prediction analysis processing (FIG. 29) executed by the future prediction analysis unit 28 on the display device 8 in accordance with the processing procedure shown in FIG. 30; and updates the content of the diagram 61 in the schedule analysis result display screen 60 in accordance with user operation using the visualization parameter designation screen 50 (FIG. 12).

Actually, the analysis result output unit 29, when called by the past result analysis unit 27 or the future prediction analysis unit 28, starts the analysis result output processing shown in FIG. 30 and firstly displays the schedule analysis result display screen 60 (FIG. 13) based on the processing result of the past result analysis processing executed by the past result analysis unit 27 or the processing result of the future prediction analysis processing executed by the future prediction analysis unit 28 on the display device 8 (S110).

Specifically, the analysis result output unit 29 displays the schedule analysis result display screen 60 including the diagram 61 in which a second line segment 62A is displayed by a color tone corresponding to the magnitude of a delay time or a predicted delay time in accordance with the delay time associated with a delay model in each station section of each train by the past result analysis unit 27 at the step S93 in the past result analysis processing (FIG. 28) or the predicted delay time associated with a delay model in each station section of each train to be targeted by the future prediction analysis unit 28 in the step S107 in the future prediction analysis processing (FIG. 29) on the display device 8.

Successively, the analysis result output unit 29: displays the visualization parameter designation screen 50 (FIG. 12) together with the schedule analysis result display screen 60 on the display device 8 (S111); and then waits for the finish button 64 (FIG. 13) in the schedule analysis result display screen 60 to be clicked or a slider 52 (FIG. 12) corresponding to any one of delay factors to be moved in the visualization parameter designation screen 50 and the value of the visualization parameter of the delay factor to be changed (S112, S113) .

Then the analysis result output unit 29, when the value (magnification) of the visualization parameter of any one of delay factors is changed in the visualization parameter designation screen 50, gives instructions to the past result analysis unit 27 or the future prediction analysis unit 28 so as to recalculate a delay time of each train in each station section in accordance with the value (magnification) of the visualization parameter of the delay factor reset at that time (S114).

Specifically, the analysis result output unit 29, when the analysis mode at that time is the past analysis mode: notifies the revised values (magnifications) of the visualization parameters of respective delay factors to the past result analysis unit 27; and then gives instructions to the past result analysis unit 27 so as to recalculate a delay time of each train in each station section. In this way, the past result analysis unit 27 that has received the instructions reexecutes the past result analysis processing stated above in reference to FIG. 28 on the basis of the values (magnifications) of the visualization parameters of the delay factors given at that time.

Then the analysis result output unit 29, when the analysis mode at that time is the future prediction mode: notifies the revised values (magnifications) of the visualization parameters of respective delay factors to the future prediction analysis unit 28; and then gives instructions to the future prediction analysis unit 28 so as to recalculate a predicted delay time in a requested station section of a requested train. In this way, the future prediction analysis unit 28 that has received the instructions reexecutes the future prediction analysis processing stated above in reference to FIG. 29 on the basis of the values (magnifications) of the visualization parameters of the delay factors given at that time of the delay factors.

Then the analysis result output unit 29 successively, when the reexecution of the past result analysis processing by the past result analysis unit 27 or the reexecution of the future prediction analysis processing by the future prediction analysis unit 28 is completed, updates the diagram 61 in the schedule analysis result display screen 60 through processing similar to the step S110 on the basis of the processing result of the past result analysis processing or the future prediction analysis processing executed at that time (S115).

Successively, the analysis result output unit 29 returns to the step S112 and then repeats the processing of the step S112 and later in the same manner as described above. Then the analysis result output unit 29, when the finish button 64 in the schedule analysis result display screen 60 is clicked soon, closes the schedule analysis result display screen 60 and the visualization parameter designation screen 50 and then finishes the analysis result output processing.

(5) Effects of present embodiment

In a schedule analysis support device 1 according to the present embodiment as stated above, during a past analysis mode, a delay time of each train in each station section is classified into delay times of respective delay factors in a targeted plan schedule and on the other hand, during a future prediction mode, a delay time obtained by predicting delay times of respective delay factors in each station section of each train and multiplying the delay times of the delay factors by the magnifications corresponding to the setting of the visualization parameters of the delay factors designated by using the visualization parameter designation screen 50 and adding up the multiplication results is displayed as a line segment 62A of a tone corresponding to the magnitude of the delay time in the schedule analysis result display screen 60 in an overlapping manner and hence a user can acquire the influences of delay factors in each of the station sections of each of the trains easily and, to that extent, it is possible to reduce work time and facilitate work in the analysis of a plan schedule. The schedule analysis support device 1 according to the present embodiment therefore can lead to a subsequent temporary operational measure and rapid operation schedule revision and resultantly the reduction of delay and congestion can be expected.

Further, in the schedule analysis support device 1, a delay time of each train in each station section after the influence of secondary delay is excluded while schedule restrictions are taken into consideration is calculated and a delay model having delay factors as the variables is generated in each of the station sections of each of the trains on the basis of the calculation result and hence an accurate delay model excluding the influence of the secondary delay can be generated and, to that extent, a user can execute more accurate schedule analysis.

(6) Other embodiments

Meanwhile, although the case of applying the present invention to the analysis of a plan schedule of a transport system using a train as the target mobile body is described in the aforementioned embodiment, the present invention is not limited to the case and can be widely applied also to the analysis of a plan schedule in a transport system using a bus, a ship, or an airplane, other than a train, as such a mobile body.

Further, although the case where the schedule analysis support device 1 has the two analysis modes of a past analysis mode and a future prediction mode as the analysis modes is described in the aforementioned embodiment, the present invention is not limited to the case and can also apply to the case where the schedule analysis support device 1 has only either of the past analysis mode and the future prediction mode.

Furthermore, although the case of displaying the processing result of the past result analysis processing and the processing result of the future prediction analysis processing in the representation forms stated above in reference to FIGS. 14B, 15B, 16B, and 17B is described in the aforementioned embodiment, the present invention is not limited to the case and can widely adopt other various representation forms as the representation forms of the processing result of the past result analysis processing and the processing result of the future prediction analysis processing.

The present invention relates to a schedule analysis support device and can widely apply to the analysis of a plan schedule in various transport systems in which a mobile body is operated in accordance with the plan schedule.

Features, components and specific details of the structures of the above-described embodiments may be exchanged or combined to form further embodiments optimized for the respective application. As far as those modifications are readily apparent for an expert skilled in the art they shall be disclosed implicitly by the above description without specifying explicitly every possible combination, for the sake of conciseness of the present description.

**Claims**

1. A schedule analysis support device to support analysis work of schedules of mobile bodies in a transport system, the device comprising:

   a model generation unit to generate a statistical model of a delay time of each of the mobile bodies to a plan schedule that is a transport schedule preplanned for the mobile body in each predetermined section on the basis of the plan schedule, an actual schedule that is a daily travel result of the mobile body, and actual values of respective delay factors in the section in chronological order;
   an analysis unit to execute at least either of past result analysis processing of classifying a first delay time that is a delay time of the mobile body in the section into second delay times that are delay times of the delay factors in the section of the mobile body on the basis of the generated statistical model and the actual values of the delay factors and future prediction analysis processing of predicting a third delay time that is a delay time of a requested mobile body in the section on the basis of the statistical model and assumed values of the delay factors with respect to a new plan schedule; and
   an output unit to display a processing result of the past result analysis processing or the future prediction analysis processing in a predetermined representation form.

2. The schedule analysis support device according to Claim 1,
   wherein the analysis unit
   in the past result analysis processing, calculates a fourth delay time by multiplying the second delay times by magnifications designated to the delay factors respectively and adding up the multiplication results of the delay factors, in each of the sections of each of the mobile bodies and
   in the future prediction analysis processing, with respect to the new plan schedule, calculates the third delay time by multiplying fifth delay times that are delay times of the respective delay factors calculated on the basis of the statistical model and the assumed values of the delay factors by magnifications designated to the delay factors respectively and adding up the multiplication results of the delay factors, in each of the sections of each of the mobile bodies; and
   the output unit displays the fourth delay time calculated in the past result analysis processing or the third delay time calculated in the future prediction analysis processing in the predetermined representation form.

3. The schedule analysis support device according to Claim 2, wherein the representation form is a form of displaying a line segment of a color tone corresponding to the magnitude of the fourth delay time or the third delay time by overlapping with a part corresponding to a corresponding section of a line segment representing a schedule of a corresponding mobile body in a diagram of the plan schedule.

4. The schedule analysis support device according to Claim 1, further comprising a delay time refinement unit to calculate the first delay time by excluding secondary delay from a fifth delay time that is a delay time of the mobile body calculated on the basis of the plan schedule and the actual schedule, in each of the sections of each of the mobile bodies,

wherein the model generation unit generates a statistical model of a delay time of the mobile body to the plan schedule in each of the sections on the basis of the first delay time calculated by the delay time refinement unit.

5. The schedule analysis support device according to Claim 4, wherein the delay time refinement unit calculates the first delay time excluding the secondary delay while the restriction of the mobile body on a target railway is taken into consideration, in each of the sections of each of the mobile bodies.

6. A schedule analysis support method executed by a schedule analysis support device to support analysis work of schedules of mobile bodies in a transport system, the method comprising:

a first step of generating a statistical model of a delay time of each of the mobile bodies to a plan schedule that is a transport schedule preplanned for the mobile body in each predetermined section on the basis of the plan schedule, an actual schedule that is a daily travel result of the mobile body, and actual values of respective delay factors in the section in chronological order;

a second step of executing at least either of past result analysis processing of classifying a first delay time that is a delay time of the mobile body in the section into second delay times that are delay times of the delay factors in the section of the mobile body on the basis of the generated statistical model and the actual values of the delay factors and future prediction analysis processing of predicting a third delay time that is a delay time of a requested mobile body in the section on the basis of the statistical model and assumed values of the delay factors with respect to a new plan schedule; and

a third step of displaying a processing result of the past result analysis processing or the future prediction analysis processing in a predetermined representation form.

7. The schedule analysis support method according to Claim 6,

wherein at the second step,

in the past result analysis processing, a fourth delay time is calculated by multiplying the second delay times by magnifications designated to the delay factors respectively and adding up the multiplication results of the delay factors, in each of the sections of each of the mobile bodies and

in the future prediction analysis processing, with respect to the new plan schedule, the third delay time is calculated by multiplying fifth delay times that are delay times of the respective delay factors calculated on the basis of the statistical model and the assumed values of the delay factors by magnifications designated to the delay factors respectively and adding up the multiplication results of the delay factors, in each of the sections of each of the mobile bodies; and

at the third step, the fourth delay time calculated in the past result analysis processing or the third delay time calculated in the future prediction analysis processing is displayed in the predetermined representation form.

8. The schedule analysis support method according to Claim 7, wherein the representation form is a form of displaying a line segment of a color tone corresponding to the magnitude of the fourth delay time or the third delay time by overlapping with a part corresponding to a corresponding section of a line segment representing a schedule of a corresponding mobile body in a diagram of the plan schedule.

9. The schedule analysis support method according to Claim 6,

wherein at the first step:

the first delay time is calculated by excluding secondary delay from a fifth delay time that is a delay time of the mobile body calculated on the basis of the plan schedule and the actual schedule, in each of the sections of each of the mobile bodies; and

a statistical model of a delay time of the mobile body to the plan schedule is generated in each of the sections on the basis of the calculated first delay time.

10. The schedule analysis support method according to Claim 9,

wherein at the first step, the first delay time excluding the secondary delay is calculated while the restriction of the mobile body on a target railway is taken into consideration, in each of the sections of each of the mobile bodies.

# FIG. 1

SCHEDULE ANALYSIS SUPPORT DEVICE — 1

| CPU ~3 | INPUT DEVICE ~7 | DISPLAY DEVICE ~8 | COMMUNICATION DEVICE ~6 |

~2

**MEMORY ~4**

**ANALYSIS PROGRAM ~20**

- MODE SETTING UNIT ~21
- PLAN SCHEDULE READ UNIT ~22
- ACTUAL DATA READ UNIT ~23
- DELAY TIME CALCULATION UNIT ~24
- DELAY TIME REFINEMENT UNIT ~25
- DELAY MODEL GENERATION UNIT ~26
- PAST RESULT ANALYSIS UNIT ~27
- FUTURE PREDICTION ANALYSIS UNIT ~28
- ANALYSIS RESULT OUTPUT UNIT ~29

**AUXILIARY STORAGE DEVICE ~5**

- PLAN SCHEDULE MANAGEMENT TABLE ~10
- ACTUAL SCHEDULE MANAGEMENT TABLE ~11
- TRAIN DELAY TIME MANAGEMENT TABLE ~12
- SCHEDULE RESTRICTION MANAGEMENT TABLE ~13
- DELAY FACTOR MANAGEMENT TABLE ~14
- POST-REFINEMENT TRAIN DELAY TIME MANAGEMENT TABLE ~15
- DELAY-FACTOR-SPECIFIC RESULT MANAGEMENT TABLE ~16
- ANALYSIS METHOD MANAGEMENT TABLE ~17
- DELAY MODEL MANAGEMENT TABLE ~18

9

# FIG. 2

PLAN SCHEDULE MANAGEMENT TABLE 10

| TRAIN NUMBER | TRAIN TYPE | UP-OR-DOWN CLASSIFICATION | ARRIVAL AND DEPARTURE TIME | | | | | |
|---|---|---|---|---|---|---|---|---|
| | | | I STATION | | ・・・ | IV STATION | | |
| | | | ARRIVAL | DEPARTURE | ・・・ | ARRIVAL | DEPARTURE | |
| 1 | LOCAL | INBOUND | FIRST TRAIN | 8:00:30 | ・・・ | 9:50:00 | LAST STOP | |
| 2 | RAPID | OUTBOUND | 8:30:00 | LAST STOP | ・・・ | 6:59:30 | 7:00:00 | |
| 3 | LOCAL | INBOUND | FIRST TRAIN | 8:02:30 | ・・・ | 9:52:00 | LAST STOP | |
| ・・・ | ・・・ | ・・・ | ・・・ | ・・・ | ・・・ | ・・・ | ・・・ | |

10A     10B     10C     10DAA   10DAB           10DAA   10DAB

10DA                    10DA

10D

# FIG. 3

ACTUAL SCHEDULE MANAGEMENT TABLE 11

| TRAIN NUMBER | TRAIN TYPE | UP-OR-DOWN CLASSIFICATION | ARRIVAL AND DEPARTURE TIME | | | | | |
|---|---|---|---|---|---|---|---|---|
| | | | I STATION | | ••• | IV STATION | | |
| | | | ARRIVAL | DEPARTURE | ••• | ARRIVAL | DEPARTURE | |
| 1 | LOCAL | INBOUND | FIRST TRAIN | 8:02:30 | ••• | 9:59:00 | LAST STOP | |
| 2 | RAPID | OUTBOUND | 8:46:00 | LAST STOP | ••• | 6:59:30 | 7:00:00 | |
| 3 | LOCAL | INBOUND | FIRST TRAIN | 8:04:30 | ••• | 10:05:00 | LAST STOP | |
| ••• | ••• | ••• | ••• | ••• | ••• | ••• | ••• | |

11A  11B  11C  11DAA  11DAB   11DAA  11DAB

11DA   11DA

11D

# FIG. 4

TRAIN DELAY TIME MANAGEMENT TABLE 12

| TRAIN NUMBER | TRAIN TYPE | UP-OR-DOWN CLASSIFICATION | SECTION-SPECIFIC DELAY TIME | | | | |
|---|---|---|---|---|---|---|---|
| | | | SECTION: I STATION TO II STATION | | ••• | SECTION: III STATION TO IV STATION | |
| | | | ARRIVAL DELAY TIME | TRAIN STOP DELAY TIME | ••• | ARRIVAL DELAY TIME | TRAIN STOP DELAY TIME |
| 1 | LOCAL | INBOUND | 00:00:00 | 00:02:00 | ••• | 00:09:00 | 00:00:00 |
| 2 | RAPID | OUTBOUND | 00:00:00 | 00:00:00 | ••• | 00:00:00 | 00:00:00 |
| 3 | LOCAL | INBOUND | 00:00:00 | 00:02:00 | ••• | 00:13:00 | 00:00:00 |
| ••• | ••• | ••• | ••• | ••• | ••• | ••• | ••• |

12A  12B  12C  12DAA  12DAB  12DAA  12DAB

12DA  12DA

12D

# FIG. 5

SCHEDULE RESTRICTION MANAGEMENT TABLE 13

| TRAIN NUMBER | RESTRICTION CONTENT |
|---|---|
| 1 | KEEP MINIMUM TRAVELING INTERVAL (2 MINUTES) FROM ANOTHER TRAIN |
| 1 | KEEP MINIMUM TRAVELING TIME (3 MINUTES) IN SECTION BETWEEN II STATION AND III STATION |
| ... | ... |

13A                    13B

# FIG. 6

DELAY FACTOR MANAGEMENT TABLE 14

| FACTOR NUMBER | FACTOR NAME |
|---|---|
| 1 | PRECIPITATION |
| 2 | WIND VELOCITY |
| 3 | SNOWFALL |
| 4 | OCCUPANCY |
| 5 | NUMBER OF PASSENGERS STAYING ON PLATFORM |
| 6 | PRESENCE OR ABSENCE OF LARGE-SCALE EVENT |
| ... | ... |

14A          14B

# FIG. 7

POST-REFINEMENT TRAIN DELAY
TIME MANAGEMENT TABLE    15

| TRAIN NUMBER | TRAIN TYPE | UP-OR-DOWN CLASSIFICATION | SECTION-SPECIFIC DELAY TIME | | | | |
|---|---|---|---|---|---|---|---|
| | | | SECTION: I STATION TO II STATION | | ... | SECTION: III STATION TO IV STATION | |
| | | | ARRIVAL DELAY TIME | TRAIN STOP DELAY TIME | ... | ARRIVAL DELAY TIME | TRAIN STOP DELAY TIME |
| 1 | LOCAL | INBOUND | 00:00:00 | 00:02:00 | ... | 00:04:00 | 00:00:00 |
| 2 | RAPID | OUTBOUND | 00:00:00 | 00:00:00 | ... | 00:00:00 | 00:00:00 |
| 3 | LOCAL | INBOUND | 00:00:00 | 00:00:00 | ... | 00:02:00 | 00:00:00 |
| ... | ... | ... | ... | ... | ... | ... | ... |

15A    15B    15C    15DAA   15DAB     15DAA   15DAB

15DA       15DA

15D

# FIG. 8

DELAY-FACTOR-SPECIFIC RESULT MANAGEMENT TABLE  16

| TRAIN NUMBER | FACTOR NUMBER | DELAY FACTOR RESULT | | |
| --- | --- | --- | --- | --- |
| | | SECTION: I STATION TO II STATION | ... | SECTION: III STATION TO IV STATION |
| 1 | 1 | 10mm | ... | 15mm |
| 1 | 2 | 1 m/s | ... | 0 m/s |
| 1 | 3 | 0mm | ... | 0mm |
| 1 | 4 | 80% | ... | 130% |
| 1 | 5 | (500P,600P) | ... | (380P,700P) |
| 1 | 6 | (0,0) | ... | (0,1) |
| 1 | ... | ... | ... | ... |
| 2 | 1 | 3mm | ... | 10mm |
| ... | ... | ... | ... | ... |

16A    16B    16CA    16CA

16C

# FIG. 9

ANALYSIS METHOD MANAGEMENT TABLE 17

| METHOD NUMBER | ANALYSIS MODE | METHOD NAME |
|---|---|---|
| 1 | FUTURE PREDICTION | MULTIPLE REGRESSION ANALYSIS |
| 2 | FUTURE PREDICTION | QUANTIFICATION THEORY TYPE I |
| 3 | PAST ANALYSIS | PRINCIPAL COMPONENT ANALYSIS |
| 4 | PAST ANALYSIS | FACTOR ANALYSIS |
| ... | ... | ... |

17A        17B        17C

# FIG. 10

DELAY MODEL MANAGEMENT TABLE 18

| ANALYSIS NUMBER | METHOD NUMBER | TRAIN NUMBER | STATION SECTION | COEFFICIENT RELATING TO DELAY FACTOR (BY FACTOR NUMBER) | | | | | | | CONSTANT |
|---|---|---|---|---|---|---|---|---|---|---|---|
| | | | | 1 | 2 | 3 | 4 | 5 | 6 | ... | |
| 1 | 1 | 1 | I STATION TO II STATION | 0.04 | 0.01 | 0 | 0.11 | (0,0.2) | (0,0) | ... | 12 SECONDS |
| 1 | 1 | 1 | ... | ... | ... | ... | ... | ... | ... | ... | 0 SECONDS |
| 1 | 1 | 1 | III STATION TO IV STATION | 0.03 | 0.05 | 0 | 0.15 | (0,0) | (0,0.2) | ... | 0 SECONDS |
| ... | ... | ... | ... | ... | ... | ... | ... | ... | ... | ... | ... |

18A  18B  18C  18D  18EA 18EA 18EA 18EA 18EA 18EA  18EB

18E

EP 3 557 506 A1

# FIG. 11

```
                                                    ⌒30
┌──────────────────────────────────────────────────────────┐
│ ANALYSIS MODE DESIGNATION              ─  ⊡  ╳           │
├──────────────────────────────────────────────────────────┤
│  ┌ ─ ─ ─ ─ ─ ─ ─ ─ ─ ─ ─ ─ ─ ─ ─ ─ ─ ─ ─ ─ ─ ─ ─ ─ ┐   │
│   ANALYSIS MODE/ANALYSIS METHOD   42A    43A          │
│  │ ☐ PAST ANALYSIS      ┌──────────┐ ┌──┐           │   │
│                         │          │ │ ▽ │          │
│  │ ☐ FUTURE PREDICTION  └──────────┘ └──┘           │   │
│   ┌──────────┐ ┌──┐                                  │
│  └ ─ ─ ─ ─ ─ ─│          │ │ ▽ │─ ─ ─ ─ ─ ─ ─ ─ ┘   │
│               └──────────┘ └──┘                         │
│                             42B    43B                   │
│  ┌ ─ ─ ─ ─ ─ ─ ─ ─ ─ ─ ─ ─ ─ ─ ─ ─ ─ ─ ─ ─ ─ ─ ─ ─ ┐   │
│   ANALYSIS TARGET PERIOD                              │
│  │         44A    45A              44B    45B        │   │
│   ┌────────────┐┌──┐     ┌────────────┐┌──┐          │
│  ││ 2018/01/01 ││ ▽│  ~  │ 2018/02/28 ││ ▽│        │   │
│   └────────────┘└──┘     └────────────┘└──┘          │
│  └ ─ ─ ─ ─ ─ ─ ─ ─ ─ ─ ─ ─ ─ ─ ─ ─ ─ ─ ─ ─ ─ ─ ─ ─ ┘   │
│                    ┌────────────┐  ┌──────────┐         │
│                    │ EXECUTION  │  │  CANCEL  │         │
│                    └────────────┘  └──────────┘         │
└──────────────────────────────────────────────────────────┘
```

31
40A
41A
41B
40B
32

33    34

# FIG. 12

50

VISUALIZATION PARAMETER — ▢ ✖

51 →

52

$\alpha$ PRECIPITATION   0.0 ————————————⬇———— 1.0

51 →

52

$\alpha$ WIND VELOCITY   0.0 ————————————⬇———— 1.0

51 →

52

$\alpha$ SNOWFALL   0.0 ————⬇———————————— 1.0

51 →

52

$\alpha$ OCCUPANCY   0.0 ————————————⬇———— 1.0

51 →

52

$\alpha$ NUMBER OF   0.0 ————————————⬇———— 1.0
STAYING PEOPLE

51 →

52

$\alpha$ EVENT   0.0 ————————————⬇———— 1.0

52

$\alpha$ ......   0.0 ————————————⬇———— 1.0

# FIG. 13

60

SCHEDULE ANALYSIS RESULT SCREEN — ▢ ✕

61

| | 6:00 | 7:00 | 8:00 | 9:00 | 10:00 |

62

STATION I

STATION II

STATION III

62

STATION IV

DELAY TIME: SMALL       DELAY TIME: LARGE    FINISH

63                     64

# FIG. 14A

50

VISUALIZATION PARAMETER  — ▢ ✖

| | | | 52 |
| --- | --- | --- | --- |
| α PRECIPITATION | 0.0 | ▽ | 1.0 |
| α WIND VELOCITY | 0.0 | ▽ | 1.0 |
| α SNOWFALL | 0.0 | ▽ | 1.0 |
| α OCCUPANCY | 0.0 | ▽ | 1.0 |
| α NUMBER OF STAYING PEOPLE | 0.0 | ▽ | 1.0 |
| α EVENT | 0.0 | ▽ | 1.0 |
| α ...... | 0.0 | ▽ | 1.0 |

52

# FIG. 14B

60

SCHEDULE ANALYSIS RESULT  — ▢ ✖

61

| | 6:00 | 7:00 | 8:00 | 9:00 | 10:00 |
| --- | --- | --- | --- | --- | --- |
| STATION I | | | | 62A | |
| STATION II | | | | | |
| STATION III | | | | | 62A |
| STATION IV | 62A | | | | |

DELAY TIME: SMALL          DELAY TIME: LARGE        FINISH

63                                                    64

# FIG. 15A

52                                    50

| VISUALIZATION PARAMETER | ▬ ▢ ✖ |

α PRECIPITATION        0.0 ▽————————————1.0
                          52

α WIND VELOCITY        0.0 ▽————————————1.0
                          52

α SNOWFALL             0.0 ▽————————————1.0
                                                    52

α OCCUPANCY            0.0————————————▽ 1.0
                          52

α NUMBER OF            0.0 ▽————————————1.0
  STAYING PEOPLE
                          52

α EVENT                0.0 ▽————————————1.0

α ......                0.0 ▽————————————1.0

                       52

# FIG. 15B

60

| SCHEDULE ANALYSIS RESULT | ▬ ▢ ✖ |

61          6:00   62A  7:00      8:00      9:00  62A  10:00

     STATION I

K1

     STATION II

     STATION III

     STATION IV        62A

| DELAY TIME: SMALL          DELAY TIME: LARGE | FINISH |

            63                                64

# FIG. 16A

50

| VISUALIZATION PARAMETER | — ▭ ✖ |

α PRECIPITATION  0.0 ——————————▽——— 1.0    52

α WIND VELOCITY  0.0 ——————————▽——— 1.0    52

α SNOWFALL  0.0 ▽————————————————— 1.0    52

α OCCUPANCY  0.0 ▽————————————————— 1.0    52

α NUMBER OF  0.0 ▽————————————————— 1.0    52
   STAYING PEOPLE

α EVENT  0.0 ▽————————————————— 1.0    52

α ......  0.0 ▽————————————————— 1.0

52

# FIG. 16B

60

| SCHEDULE ANALYSIS RESULT | — ▭ ✖ |

61

6:00        7:00        8:00        9:00        10:00

STATION I

STATION II

STATION III

62A

K2

STATION IV

62A

DELAY TIME: SMALL        DELAY TIME: LARGE    FINISH

63                                              64

# FIG. 17A

52    50

| VISUALIZATION PARAMETER | ▬ ⬚ ✖ |

α PRECIPITATION    0.0 ▽——————————1.0

52

α WIND VELOCITY    0.0 ▽——————————1.0

52

α SNOWFALL    0.0 ▽——————————1.0

52

α OCCUPANCY    0.0 ▽——————————1.0

52

α NUMBER OF
  STAYING PEOPLE    0.0 ▽——————————1.0

52

α EVENT    0.0 ▽——————————1.0

52

α ......    0.0 ▽——————————1.0

52

# FIG. 17B

60

| SCHEDULE ANALYSIS RESULT | ▬ ⬚ ✖ |

61

6:00    7:00    8:00    9:00    10:00

STATION I

STATION II

STATION III

STATION IV

62A    62A

DELAY TIME: SMALL    DELAY TIME: LARGE    FINISH

63    K3    64

# FIG. 18

82

~70

| SIMULATION SETTING | — ⬜ ✕ |

80

□ PRECIPITATION        : 0mm

□ WIND VELOCITY        : 1m/s
81        □ SNOWFALL             : 0mm        82
□ OCCUPANCY            : 120%

□ NUMBER OF STAYING    : (300P,200P)
PEOPLE (300 PEOPLE,
200 PEOPLE)
□ PRESENCE OR ABSENCE : (YES,NO)
OF EVENT
(PRESENCE, ABSENCE)
□ ···

~71

72A
72C

72B  ◀ TARGET TRAIN NUMBER
(STATION SECTION): 1 (I STATION TO II STATION) ▶   72

ESTIMATED ENVIRONMENT READ BUTTON   73

COLLECTIVE SETTING BUTTON   74

| EXECUTION | CANCEL |

75        76

# FIG. 19

## SCHEDULE ANALYSIS PROCESSING

START

MODE SETTING PROCESSING — S1

PLAN SCHEDULE READ PROCESSING — S2

ACTUAL DATA READ PROCESSING — S3

DELAY TIME CALCULATION PROCESSING — S4

DELAY TIME REFINEMENT PROCESSING — S5

DELAY MODEL GENERATION PROCESSING — S6

S7 — PAST RESULT ANALYSIS PROCESSING

S8 — FUTURE PREDICTION ANALYSIS PROCESSING

ANALYSIS RESULT OUTPUT PROCESSING — S9

NO — IS ANALYSIS COMPLETED? — S10

YES

FINISH

# FIG. 20

MODE SETTING PROCESSING

```
        ┌─────────────┐
        │    START    │
        └──────┬──────┘
               │
               ▼
     ┌──────────────────────┐
     │ DISPLAY ANALYSIS MODE │ ～S20
     │  DESIGNATION SCREEN   │
     └──────────┬───────────┘
               │
               ▼
              ╱╲  ～S21
            ╱    ╲                    YES
          ╱ IS PAST ╲──────────────────────────┐
          ╲ ANALYSIS MODE? ╱                     │
            ╲        ╱                           │
              ╲╱                                 │
               │ NO                              │
               ▼                                 │
              ╱╲  ～S23                           │
     NO     ╱    ╲                               │
  ┌───────╱ IS FUTURE ╲                          │
  │       ╲ PREDICTION MODE? ╱                   │
  │         ╲        ╱                           │
  │           ╲╱                                 │
  │            │ YES                             │
  │            ▼                                 ▼
  │   ┌──────────────────┐         ┌──────────────────────┐
  │   │   SET FUTURE     │～S24     │ SET PAST ANALYSIS MODE│～S22
  │   │  PREDICTION MODE │         └───────────┬──────────┘
  │   └────────┬─────────┘                     │
  │            │◄───────────────────────────────┘
  │            ▼
  │   ┌─────────────┐
  │   │   FINISH    │
  │   └─────────────┘
```

# FIG. 21

PLAN SCHEDULE READ PROCESSING

```
        ┌──────────────┐
        │    START     │
        └──────────────┘
               │
               ▼
   ┌──────────────────────────┐
   │   SELECT PLAN SCHEDULE    │───S30
   └──────────────────────────┘
               │
               ▼
   ┌──────────────────────────┐
   │    READ PLAN SCHEDULE     │───S31
   └──────────────────────────┘
               │
               ▼
        ┌──────────────┐
        │   FINISH     │
        └──────────────┘
```

# FIG. 22

ACTUAL DATA READ PROCESSING

```
        ┌──────────────┐
        │    START     │
        └──────────────┘
               │
               ▼
   ┌──────────────────────────┐
   │   SELECT ACTUAL SCHEDULE  │───S40
   └──────────────────────────┘
               │
               ▼
   ┌──────────────────────────┐
   │ READ ACTUAL SCHEDULE DURING│
   │ DESIGNATED ANALYSIS        │───S41
   │ TARGET PERIOD              │
   └──────────────────────────┘
               │
               ▼
   ┌──────────────────────────┐
   │ READ DELAY FACTOR RESULT  │
   │ INFORMATION DURING         │───S42
   │ DESIGNATED ANALYSIS TARGET │
   │ PERIOD                     │
   └──────────────────────────┘
               │
               ▼
        ┌──────────────┐
        │   FINISH     │
        └──────────────┘
```

# FIG. 23

DELAY TIME CALCULATION PROCESSING

START

SELECT DATE — S50

SELECT RAIN — S51

SELECT STATION — S52

EXTRACT ARRIVAL AND DEPARTURE TIMES OF TARGETED TRAIN/STATION — S53

ARE THEY EXTRACTED? — S54
NO / YES

CALCULATE ARRIVAL DELAY TIME — S55

CALCULATE TRAIN STOP DELAY TIME — S56

REGISTER CALCULATION RESULT — S57

ARE ALL STATIONS COMPLETED? — S58
NO / YES

ARE ALL TRAINS COMPLETED? — S59
NO / YES

ARE ALL DATES COMPLETED? — S60
NO / YES

FINISH

# FIG. 24

## DELAY TIME REFINEMENT PROCESSING

START

SELECT DATE — S70

SELECT TRAIN — S71

ACQUIRE ACTUAL SCHEDULE (DEPARTURE AND ARRIVAL TIMES) — S72

ACQUIRE SCHEDULE RESTRICTION OF IDENTICAL TRAIN NUMBER — S73

SELECT STATION SECTION — S74

CALCULATE DELAY TIME EXCLUDING SECONDARY DELAY IN CONSIDERATION OF SCHEDULE RESTRICTION CONDITION — S75

REGISTER REFINED DELAY TIME — S76

ARE ALL STATION SECTIONS COMPLETED? — S77
NO
YES

ARE ALL TRAINS COMPLETED? — S78
NO
YES

ARE ALL DATES COMPLETED? — S79
NO
YES

FINISH

# FIG. 25A

~12

| TRAIN NUMBER | TRAIN TYPE | UP-OR-DOWN CLASSI-FICATION | SECTION-SPECIFIC DELAY TIME | |
|---|---|---|---|---|
| | | | SECTION: I STATION TO II STATION | SECTION: III STATION TO IV STATION |
| | | | ARRIVAL DELAY TIME | ARRIVAL DELAY TIME |
| 1 | LOCAL | OUTBOUND | 00:00:00 | 00:04:00 |
| 2 | LOCAL | OUTBOUND | 00:00:00 | 00:06:00 |

# FIG. 25B

~13

| TRAIN NUMBER | RESTRICTION CONTENT |
|---|---|
| . . . | . . . |
| 2 | KEEP MINIMUM TRAVELING INTERVAL (2 MINUTES) FROM ANOTHER TRAIN |
| 2 | O KEEP MINIMUM TRAVELING TIME (3 MINUTES) IN SECTION BETWEEN II STATION AND III STATION |
| . . . | . . . |

# FIG. 25C

I STATION ─────────
II STATION ─────────
III STATION ─────────

- - PLAN
── RESULT

1   2

4 MINUTES ←X→ ←Y→

6 MINUTES

# FIG. 25D

~15

| TRAIN NUMBER | TRAIN TYPE | UP-OR-DOWN CLASSI-FICATION | SECTION-SPECIFIC DELAY TIME | |
|---|---|---|---|---|
| | | | SECTION: I STATION TO II STATION | SECTION: III STATION TO IV STATION |
| | | | ARRIVAL DELAY TIME | ARRIVAL DELAY TIME |
| 1 | LOCAL | OUTBOUND | 00:00:00 | 00:04:00 |
| 2 | LOCAL | OUTBOUND | 00:00:00 | 00:04:00 |

# FIG. 26A

~12

| TRAIN NUMBER | TRAIN TYPE | UP-OR-DOWN CLASSI-FICATION | SECTION-SPECIFIC DELAY TIME | |
|---|---|---|---|---|
| | | | SECTION: I STATION TO II STATION | SECTION: III STATION TO IV STATION |
| | | | ARRIVAL DELAY TIME | ARRIVAL DELAY TIME |
| 1 | LOCAL | OUTBOUND | 00:04:00 | 00:10:00 |

# FIG. 26B

~13

| TRAIN NUMBER | RESTRICTION CONTENT |
|---|---|
| 1 | KEEP MINIMUM TRAVELING INTERVAL (2 MINUTES) FROM ANOTHER TRAIN |
| 1 | O KEEP MINIMUM TRAVELING TIME (3 MINUTES) IN SECTION BETWEEN II STATION AND III STATION |
| ... | ... |

# FIG. 26C

- - PLAN
— RESULT
DEPARTURE 10:05:00
ARRIVAL 10:11:00
I STATION
II STATION
III STATION
1
10 MINUTES
X
Y
3 MINUTES

# FIG. 26D

~15

| TRAIN NUMBER | TRAIN TYPE | UP-OR-DOWN CLASSI-FICATION | SECTION-SPECIFIC DELAY TIME | |
|---|---|---|---|---|
| | | | SECTION: I STATION TO II STATION | SECTION: III STATION TO IV STATION |
| | | | ARRIVAL DELAY TIME | ARRIVAL DELAY TIME |
| 1 | LOCAL | OUTBOUND | 00:04:00 | 00:03:00 |

# FIG. 27

DELAY MODEL GENERATION PROCESSING

```
        ┌──────────────┐
        │    START     │
        └──────────────┘
               │
               ▼
  ┌─────────────────────────┐
  │  CONFIRM ANALYSIS MODE  │──S80
  │  AND ANALYSIS METHOD    │
  └─────────────────────────┘
               │
               ▼
  ┌─────────────────────────┐
  │  GENERATE DELAY MODEL BY│──S81
  │  DESIGNATED ANALYSIS METHOD│
  └─────────────────────────┘
               │
               ▼
  ┌─────────────────────────┐
  │  RESERVE GENERATED      │──S82
  │  DELAY MODEL            │
  └─────────────────────────┘
               │
               ▼
        ┌──────────────┐
        │    FINISH    │
        └──────────────┘
```

# FIG. 28

PAST RESULT ANALYSIS PROCESSING

START

SELECT TRAIN AND STATION SECTION — S90

READ CORRESPONDING DELAY MODEL — S91

MULTIPLY COEFFICIENT BY VALUE OF VISUALIZATION PARAMETER AND ACTUAL VALUE — S92

LINK CALCULATED DELAY TIME TO CORRESPONDING DELAY MODEL — S93

S94

NO ← ARE ALL COMBINATIONS COMPLETED?

YES

FINISH

# FIG. 29

FUTURE PREDICTION ANALYSIS PROCESSING

START

READ PLAN SCHEDULE —— S100

DISPLAY SIMULATION
SETTING SCREEN —— S101

READ SETTING CONTENT —— S102

SELECT TRAIN AND STATION SECTION —— S103

READ CORRESPONDING DELAY MODEL —— S104

CALCULATE DELAY-FACTOR
-SPECIFIC DELAY TIMES —— S105

MULTIPLY DELAY-FACTOR-SPECIFIC
DELAY TIMES BY VALUES OF
CORRESPONDING VISUALIZATION
PARAMETERS RESPECTIVELY —— S106

LINK CALCULATED DELAY TIME TO
CORRESPONDING DELAY MODEL —— S107

NO ARE ALL COMBINATIONS
COMPLETED? —— S108

YES

FINISH

# FIG. 30

## ANALYSIS RESULT OUTPUT PROCESSING

```
                    ┌──────────────┐
                    │    START     │
                    └──────────────┘
                            │
                            ▼
        ┌──────────────────────────────────────┐
        │ DISPLAY SCHEDULE DISPLAY SCREEN      │──S110
        └──────────────────────────────────────┘
                            │
                            ▼
        ┌──────────────────────────────────────┐
        │ DISPLAY VISUALIZATION PARAMETER      │──S111
        │ DESIGNATION SCREEN                    │
        └──────────────────────────────────────┘
                            │
                            ▼
                    ◇ S112            YES
        ◇ IS ANALYSIS FINISHED? ◇────────────┐
                            │                 │
                           NO                 │
                            ▼                 │
                    ◇ S113                    │
   NO  ◇ IS PARAMETER VALUE CHANGED? ◇        │
  ◄─────                                       │
                           YES                │
                            ▼                 │
        ┌──────────────────────────────────┐  │
        │ INSTRUCT RECALCULATION           │──S114
        │ OF DELAY TIME                     │  │
        └──────────────────────────────────┘  │
                            │                 │
                            ▼                 │
        ┌──────────────────────────────────┐  │
        │ UPDATE SCHEDULE DISPLAY SCREEN   │──S115
        └──────────────────────────────────┘  │
                            │                 │
                            ▼                 │
                    ┌──────────────┐          │
                    │   FINISH     │◄─────────┘
                    └──────────────┘
```

50

Europäisches
Patentamt

European
Patent Office

Office européen
des brevets

# EUROPEAN SEARCH REPORT

Application Number

EP 19 16 1902

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2014/091055 A1 (UNIV ILLES BALEARS [ES]) 19 June 2014 (2014-06-19) * paragraphs [0003], [0007], [0048], [0050], [0051], [0068], [0081] * ----- | 1-10 | INV. G06Q10/04 G06Q10/06 G06Q50/30 |
| X | US 2016/055275 A1 (WANG MENGJIAO [CN] ET AL) 25 February 2016 (2016-02-25) * paragraphs [0004] - [0016] * ----- | 1-10 | |
| X | US 2007/219833 A1 (TRAUTMAN PHILIP L [US]) 20 September 2007 (2007-09-20) * paragraphs [0008] - [0011] * ----- | 1-10 | |
| A | EP 0 782 521 A1 (HARRIS CORP [US]) 9 July 1997 (1997-07-09) * paragraphs [0001] - [0036] * ----- | 1-10 | |
| A | GB 2 497 706 A (HITACHI LTD [JP]) 19 June 2013 (2013-06-19) * paragraphs [0006] - [0016] * ----- | 1-10 | |

TECHNICAL FIELDS
SEARCHED (IPC)

G06Q

The present search report has been drawn up for all claims

| Place of search | Date of completion of the search | Examiner |
|---|---|---|
| Munich | 26 April 2019 | Breidenich, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 16 1902

This annex lists the patent family members relating to the patent documents cited in the above-mentioned European search report.
The members are as contained in the European Patent Office EDP file on
The European Patent Office is in no way liable for these particulars which are merely given for the purpose of information.

26-04-2019

| Patent document cited in search report | | Publication date | Patent family member(s) | | Publication date |
|---|---|---|---|---|---|
| WO 2014091055 | A1 | 19-06-2014 | ES | 2476566 A1 | 14-07-2014 |
| | | | WO | 2014091055 A1 | 19-06-2014 |
| US 2016055275 | A1 | 25-02-2016 | NONE | | |
| US 2007219833 | A1 | 20-09-2007 | NONE | | |
| EP 0782521 | A1 | 09-07-1997 | AT | 343503 T | 15-11-2006 |
| | | | AU | 712538 B2 | 11-11-1999 |
| | | | BR | 9509462 A | 21-10-1997 |
| | | | CA | 2198855 A1 | 07-03-1996 |
| | | | CN | 1162290 A | 15-10-1997 |
| | | | DE | 69535279 T2 | 24-05-2007 |
| | | | EP | 0782521 A1 | 09-07-1997 |
| | | | EP | 1764280 A1 | 21-03-2007 |
| | | | JP | H10505036 A | 19-05-1998 |
| | | | PL | 319030 A1 | 21-07-1997 |
| | | | US | 5623413 A | 22-04-1997 |
| | | | US | 5794172 A | 11-08-1998 |
| | | | US | 6154735 A | 28-11-2000 |
| | | | WO | 9606766 A1 | 07-03-1996 |
| | | | ZA | 9507360 B | 28-08-1996 |
| GB 2497706 | A | 19-06-2013 | GB | 2497706 A | 19-06-2013 |
| | | | JP | 5504127 B2 | 28-05-2014 |
| | | | JP | 2012081887 A | 26-04-2012 |
| | | | WO | 2012049929 A1 | 19-04-2012 |

EPO FORM P0459

For more details about this annex : see Official Journal of the European Patent Office, No. 12/82

**EP 3 557 506 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008114779 A